# EUROPEAN PATENT APPLICATION

(11) **EP 4 564 412 A2**
(43) Date of publication of application: **04.06.2025**
(21) Application number: 24215477.1
(22) Date of filing: 26.11.2024
(51) Int. Cl.: H01L 21/67, H01L 21/677

(54) **SUBSTRATE PROCESSING SYSTEM AND SUBSTRATE PROCESSING METHOD**

(30) Priority: 29.11.2023 JP 2023202101
(71) Applicant: SCREEN Holdings Co., Ltd., Kyoto-shi, Kyoto 602-8585 (JP)
(72) Inventor: Taniguchi, Shinichi, 602-8585 Kyoto (JP); Iwasaki, Akihiro, 602-8585 Kyoto (JP)
(74) Representative: Kilian Kilian & Partner mbB

(57) **Abstract**

A controller of a substrate processing system controls a lifter to perform first batch processing to immerse a plurality of substrates in a vertical attitude in a chemical liquid in a chemical treatment tank. The controller controls a second attitude changing mechanism to rotate the plurality of substrates subjected to the first batch processing about a horizontal axis, to vertically invert the plurality of substrates in the vertical attitude. The controller controls the lifter to perform second batch processing to immerse the plurality of vertically-inverted substrates in the vertical attitude in the chemical liquid in the chemical treatment tank.

## Description

### BACKGROUND

### Technical Field

The present invention relates to a substrate processing system and a substrate processing method for processing a substrate. Examples of the substrate include a semiconductor substrate, a substrate for a flat panel display (FPD), a glass substrate for a photomask, a substrate for an optical disk, a substrate for a magnetic disk, a ceramic substrate, and a substrate for a solar cell. Examples of the FPD include a liquid crystal display device and an organic electroluminescence (EL) display device.

### Related Art

A conventional substrate processing apparatus includes a substrate transport mechanism that transports a substrate group to be collectively processed, a processing tank that stores a heated phosphoric acid solution, and a lifter that holds the substrate group and immerses the substrate group in the phosphoric acid solution. When the substrate transport mechanism transports the substrate group to the processing tank, the lifter receives the substrate group from the substrate transport mechanism and immerses the substrate group in the phosphoric acid solution in the processing tank. As a result, the substrate group is collectively subjected to an etching treatment (see, for example, JP 2004-296823 A).

JP 2021-064652 A discloses a substrate processing system including a batch processing part that collectively processes a plurality of substrates, a single-wafer processing part that processes the substrates one by one, and an interface part that delivers the substrates between the single-wafer processing part and the batch processing part.

### SUMMARY

A plurality of substrates in a vertical attitude are immersed in the phosphoric acid solution in the processing tank. As a result, the plurality of substrates are collectively subjected to the etching treatment. At this time, in order to circulate the phosphoric acid solution in the processing tank, for example, at least either of the phosphoric acid solution and air bubbles is caused to flow upward from a bottom of the processing tank. Such an etching treatment is performed until a preset time (for example, four hours) elapses. However, the degree of etching may be different between the upper half and the lower half of each substrate in the vertical attitude, probably due to the fact that the closer to the bottom of the processing tank a place is, the fresher phosphoric acid solution acts on the substrate.

The present invention has been made in view of such circumstances, and an object thereof is to provide a substrate processing system and a substrate processing method capable of reducing processing variations in each substrate.

In order to achieve such an object, the present invention has the following configuration. That is, a substrate processing system for processing a substrate according to the present invention includes a batch processing apparatus configured to collectively process a plurality of substrates, the batch processing apparatus including: a first carrier placement shelf on which a carrier accommodating the plurality of substrates in a horizontal attitude is placed; a first attitude changing mechanism configured to change the plurality of substrates between the horizontal attitude and a vertical attitude; a substrate handling mechanism configured to transport the plurality of substrates between the carrier placed on the first carrier placement shelf and the first attitude changing mechanism; a processing tank storing a chemical liquid; a lifter configured to be able to immerse the plurality of substrates in the chemical liquid in the processing tank while holding the plurality of substrates in the vertical attitude; a second attitude changing mechanism configured to rotate the plurality of substrates about a horizontal axis orthogonal to a central axis passing through the center of each substrate; a first batch transport robot configured to transport the plurality of substrates among the first attitude changing mechanism, the lifter, and the second attitude changing mechanism while holding the plurality of substrates in the vertical attitude; and a controller, the controller controlling the substrate handling mechanism to transport the plurality of substrates in the horizontal attitude received from the carrier placed on the first carrier placement shelf, to the first attitude changing mechanism, controlling the first attitude changing mechanism to change the plurality of substrates from the horizontal attitude to the vertical attitude, controlling the first batch transport robot to transport the plurality of substrates changed to the vertical attitude to the lifter, controlling the lifter to perform first batch processing to immerse the plurality of substrates in the vertical attitude in the chemical liquid in the processing tank, controlling the first batch transport robot to transport the plurality of substrates subjected to the first batch processing to the second attitude changing mechanism, controlling the second attitude changing mechanism to rotate the plurality of substrates subjected to the first batch processing about the horizontal axis, to vertically invert the plurality of substrates in the vertical attitude, controlling the first batch transport robot to transport the plurality of vertically-inverted substrates in the vertical attitude to the lifter, and controlling the lifter to perform second batch processing to immerse the plurality of vertically-inverted substrates in the vertical attitude in the chemical liquid in the processing tank.

According to the substrate processing system of the present invention, the first batch processing and the second batch processing in which the plurality of substrates are immersed in the chemical liquid in the processing tank are performed. Here, the second attitude changing mechanism rotates the plurality of substrates subjected to the first batch processing about the horizontal axis, thereby vertically inverting the plurality of substrates in the vertical attitude. That is, the operation of vertically inverting the plurality of substrates in the vertical attitude is performed between the first batch processing and the second batch processing. This makes it possible to reduce processing variations occurring between the upper half and the lower half of each substrate.

In the above-described substrate processing system, it is preferable that the second attitude changing mechanism includes a reversing chuck configured to hold the plurality of substrates, and rotates the reversing chuck about the horizontal axis. The operation of vertically inverting the plurality of substrates in the vertical attitude is performed by rotating the reversing chuck holding the plurality of substrates about the horizontal axis.

In the above-described substrate processing system, it is preferable that the reversing chuck includes two chuck members including a plurality of pairs of holding grooves, the two chuck members are openable and closable along the horizontal axis, and each of the plurality of pairs of holding grooves includes a first support portion configured to stop movement of one of the substrates to be accommodated in a predetermined direction out of substrate in/out directions orthogonal to a direction in which the two chuck members are opened and closed, the substrate in/out directions being along a device surface of the one substrate to be accommodated, and a second support portion configured to stop movement of the one substrate to be accommodated in a direction opposite to the predetermined direction.

In the reversing chuck, the first support portion and the second support portion of each pair of holding grooves can stop the movement of the one substrate in both the substrate in/out directions. This makes it possible to easily perform the operation of vertically inverting the plurality of substrates in the vertical attitude.

It is preferable that the above-described substrate processing system further includes a first horizontal substrate transport robot including a first hand holding one of the substrates in the horizontal attitude and configured to transport the one substrate, the controller controlling the second attitude changing mechanism to rotate the reversing chuck about the horizontal axis while holding the plurality of substrates by the reversing chuck, to change the plurality of substrates subjected to the first batch processing from the vertical attitude to the horizontal attitude, controlling the first horizontal substrate transport robot to perform a rearrangement operation of rearranging the plurality of substrates changed to the horizontal attitude in the reversing chuck so as to exchange positions of an outer substrate and an inner substrate in a direction in which the plurality of substrates are arranged, and controlling the second attitude changing mechanism to further rotate the reversing chuck about the horizontal axis while holding the plurality of substrates by the reversing chuck, to change the plurality of substrates subjected to the rearrangement operation from the horizontal attitude to the vertical attitude so as to vertically invert the plurality of substrates in the vertical attitude obtained when the first batch processing is performed.

The rearrangement operation is performed in addition to the operation of vertically inverting the plurality of substrates in the vertical attitude. The rearrangement operation is an operation of rearranging the plurality of substrates changed to the horizontal attitude in the reversing chuck so as to exchange the positions of the outer substrate and the inner substrate in the direction in which the plurality of substrates are arranged. This makes it possible to reduce processing variations occurring between the outer substrate and the inner substrate in the direction in which the plurality of substrates are arranged.

It is preferable that the above-described substrate processing system further includes: a single-wafer processing apparatus configured to process the plurality of substrates one by one; and a relay apparatus configured to transport the plurality of substrates from the batch processing apparatus to the single-wafer processing apparatus, in addition to the batch processing apparatus, the relay apparatus including a first horizontal substrate transport robot including a first hand holding one of the substrates in the horizontal attitude and configured to transport the one substrate, the single-wafer processing apparatus including: a single-wafer processing chamber configured to perform single-wafer processing on the one substrate in the horizontal attitude; a second carrier placement shelf on which the carrier is placed; and a second horizontal substrate transport robot including a second hand holding the one substrate in the horizontal attitude and configured to transport the one substrate among the relay apparatus, the single-wafer processing chamber, and the carrier placed on the second carrier placement shelf, the controller controlling the first batch transport robot to transport the plurality of substrates subjected to the second batch processing to the second attitude changing mechanism, controlling the second attitude changing mechanism to change the plurality of substrates subjected to the second batch processing from the vertical attitude to the horizontal attitude, controlling the first horizontal substrate transport robot to transport the one substrate changed to the horizontal attitude from the second attitude changing mechanism to the single-wafer processing apparatus, controlling the second horizontal substrate transport robot to transport the one substrate transported by the first horizontal substrate transport robot to the single-wafer processing chamber, controlling the single-wafer processing chamber to perform the single-wafer processing on the one substrate, and controlling the second horizontal substrate transport robot to transport the one substrate subjected to the single-wafer processing from the single-wafer processing chamber to the carrier placed on the second carrier placement shelf.

The substrate processing system includes the single-wafer processing apparatus and the relay apparatus in addition to the batch processing apparatus. The plurality of substrates subjected to the second batch processing are sent to the single-wafer processing apparatus through the relay apparatus. Here, in addition to the operation of vertically inverting the plurality of substrates in the vertical attitude, the second attitude changing mechanism performs the operation of changing the plurality of substrates from the vertical attitude to the horizontal attitude. In other words, the second attitude changing mechanism performs the vertical inversion operation in addition to the changing operation to the horizontal attitude. Therefore, it is not necessary to separately provide a mechanism for performing the change to the horizontal attitude and a mechanism for performing the vertical inversion operation, so that the substrate processing system can be configured compactly.

In the above-described substrate processing system, it is preferable that the controller controls the substrate handling mechanism to transport the plurality of substrates in the horizontal attitude received from a first carrier placed on the first carrier placement shelf to the first attitude changing mechanism, and to transport a plurality of second substrates in a horizontal attitude received from a second carrier placed on the first carrier placement shelf to the first attitude changing mechanism, controls the first attitude changing mechanism to form a processing substrate group in which the plurality of substrates and the plurality of second substrates are alternately disposed, and to change the processing substrate group from the horizontal attitude to the vertical attitude,
controls the first batch transport robot to transport the processing substrate group in the vertical attitude to the lifter, controls the lifter to perform the first batch processing to immerse the processing substrate group in the chemical liquid in the processing tank, controls the first batch transport robot to transport the processing substrate group subjected to the first batch processing to the second attitude changing mechanism, controls the second attitude changing mechanism to rotate the plurality of substrates in the processing substrate group subjected to the first batch processing about the horizontal axis, and to rotate the plurality of second substrates in the processing substrate group subjected to the first batch processing about the horizontal axis, to vertically invert the plurality of substrates and the plurality of second substrates in the vertical attitude, controls the first batch transport robot to transport the vertically-inverted processing substrate group in the vertical attitude to the lifter, and controls the lifter to perform the second batch processing to immerse the vertically-inverted processing substrate group in the vertical attitude in the chemical liquid in the processing tank.

The substrate processing system can reduce processing variations occurring between the upper half and the lower half of each substrate of the processing substrate group by vertically inverting the processing substrate group in which the plurality of substrates and the plurality of second substrates are alternately disposed.

In the above-described substrate processing system, it is preferable that the second attitude changing mechanism further includes: a standby lifter configured to hold the processing substrate group in the vertical attitude; and a second batch transport robot configured to transport the processing substrate group between the standby lifter and the reversing chuck, and the controller controls the first attitude changing mechanism to form the processing substrate group in which the plurality of substrates and the plurality of second substrates are alternately disposed and all device surfaces of the plurality of substrates and all device surfaces of the plurality of second substrates face each other, and to change the processing substrate group from the horizontal attitude to the vertical attitude, and controls the second batch transport robot to transport the plurality of vertically-inverted substrates and the plurality of vertically-inverted second substrates to the standby lifter so as to make all the device surfaces of the plurality of substrates and all the device surfaces of the plurality of second substrates face each other.

The processing substrate group is formed such that the plurality of substrates and the plurality of second substrates are alternately disposed and all the device surfaces of the plurality of substrates and all the device surfaces of the plurality of second substrates face each other. It is assumed that two device surfaces of two substrates at opposite ends do not face two device surfaces of other two substrates in a direction in which the processing substrate group is arranged after the processing substrate group is vertically inverted. In this case, when the batch processing is performed, for example, a different amount of chemical liquid flows between the substrate whose device surface faces no device surface and two substrates whose device surfaces face each other. Thus, there is a possibility of causing processing variations. Such processing variations can be prevented by making all the device surfaces of the plurality of substrates and all the device surfaces of the plurality of second substrates face each other after the processing substrate group is vertically inverted.

In the above-described substrate processing system, it is preferable that the batch processing apparatus further includes a batch dryer configured to collectively dry the plurality of substrates, the first batch transport robot is configured to transport the plurality of substrates among the first attitude changing mechanism, the lifter, the second attitude changing mechanism, and the batch dryer while holding the plurality of substrates in the vertical attitude, and the controller controls the first batch transport robot to transport the plurality of substrates subjected to the second batch processing to the batch dryer, and controls the batch dryer to collectively dry the plurality of substrates subjected to the second batch processing.

The substrate processing system can collectively dry the plurality of substrates subjected to the second batch processing using the batch dryer without sending the plurality of substrates subjected to the second batch processing to the single-wafer processing apparatus.

A substrate processing method according to the present invention is a substrate processing method for a substrate processing system including a batch processing apparatus configured to collectively process a plurality of substrates, the batch processing apparatus including: a carrier placement shelf on which a carrier accommodating the plurality of substrates in a horizontal attitude is placed; a first attitude changing mechanism configured to change the plurality of substrates between the horizontal attitude and a vertical attitude; a substrate handling mechanism configured to transport the plurality of substrates between the carrier placed on the carrier placement shelf and the first attitude changing mechanism; a processing tank storing a chemical liquid; a lifter configured to be able to immerse the plurality of substrates in the chemical liquid in the processing tank while holding the plurality of substrates in the vertical attitude; and a first batch transport robot configured to transport the plurality of substrates while holding the plurality of substrates in the vertical attitude, the substrate processing method including: a first substrate transport step of causing the substrate handling mechanism to transport the plurality of substrates in the horizontal attitude received from the carrier placed on the carrier placement shelf, to the first attitude changing mechanism; a vertical attitude changing step of causing the first attitude changing mechanism to change the plurality of substrates from the horizontal attitude to the vertical attitude; a second substrate transport step of causing the first batch transport robot to transport the plurality of substrates changed to the vertical attitude to the lifter; a first batch processing step of causing the lifter to perform first batch processing to immerse the plurality of substrates in the vertical attitude in the chemical liquid in the processing tank; a third substrate transport step of causing the first batch transport robot to transport the plurality of substrates subjected to the first batch processing to a second attitude changing mechanism; a vertical inversion step of causing the second attitude changing mechanism to rotate the plurality of substrates subjected to the first batch processing about a horizontal axis orthogonal to a central axis passing through the center of each substrate, to vertically invert the plurality of substrates in the vertical attitude; a fourth substrate transport step of causing the first batch transport robot to transport the plurality of vertically-inverted substrates in the vertical attitude to the lifter; and a second batch processing step of causing the lifter to perform second batch processing to immerse the plurality of vertically-inverted substrates in the vertical attitude in the chemical liquid in the processing tank.

The substrate processing system and the substrate processing method according to the present invention can reduce processing variations in each substrate.

### BRIEF DESCRIPTION OF DRAWINGS

For the purpose of illustrating the invention, there are shown in the drawings several forms which are presently preferred, it being understood, however, that the invention is not limited to the precise arrangement and instrumentalities shown.
FIG. 1 is a plan view illustrating a schematic configuration of a substrate processing system according to a first embodiment;
FIGS. 2A to 2C are side views for explaining a substrate handling mechanism and a first attitude changing mechanism;
FIGS. 3A and 3B are plan views of a standby tank, a standby lifter, and a batch transport robot;
FIG. 4 is a longitudinal sectional view of an attitude changing tank and an attitude changer as viewed from the front;
FIG. 5A is a front view illustrating a state in which a reversing chuck in an open state supports a plurality of substrates, and FIG. 5B is a cross sectional view illustrating a state in which a pair of holding grooves of the reversing chuck in an open state supports one substrate in a horizontal attitude;
FIG. 6 is a flowchart for explaining an operation of the substrate processing system;
FIG. 7 is a flowchart for explaining a first-half operation of batch processing (chemical treatment and cleaning treatment);
FIG. 8 is a flowchart for explaining a latter-half operation of the batch processing;
FIGS. 9A to 9C are side views for explaining an operation of a second attitude changing mechanism;
FIGS. 10A to 10C are side views for explaining the operation of the second attitude changing mechanism;
FIGS. 11A to 11C are side views for explaining the operation of the second attitude changing mechanism;
FIGS. 12A to 12C are side views for explaining the operation of the second attitude changing mechanism;
FIGS. 13A to 13C are side views for explaining the operation of the second attitude changing mechanism;
FIG. 14A is a side view for explaining an operation of changing a first substrate group to a horizontal attitude, and FIG. 14B is a side view illustrating a state in which a relay hand of a substrate transport robot accesses the reversing chuck in order to take out one substrate;
FIG. 15 is a side view for explaining an operation of changing a second substrate group to a horizontal attitude;
FIG. 16 is a drawing for explaining an effect of the substrate processing system;
FIG. 17 is a flowchart illustrating a detailed vertical inversion operation of 25 substrates by a reversing chuck according to a second embodiment;
FIG. 18A is a longitudinal sectional view illustrating a state before a plurality of substrates are vertically inverted, FIG. 18B is a longitudinal sectional view illustrating a state in which the plurality of substrates are changed from a vertical attitude to a horizontal attitude, and FIG. 18C is a longitudinal sectional view illustrating a state in which the plurality of substrates are changed from the horizontal attitude to the vertical attitude (a state after the vertical inversion);
FIGS. 19A to 19G are front views for explaining a substrate rearrangement operation in the reversing chuck according to the second embodiment;
FIG. 20 is a plan view illustrating a schematic configuration of another substrate processing system according to a third embodiment; and
FIG. 21 is a flowchart for explaining an operation of the substrate processing system according to the third embodiment.

### DETAILED DESCRIPTION

### [First Embodiment]

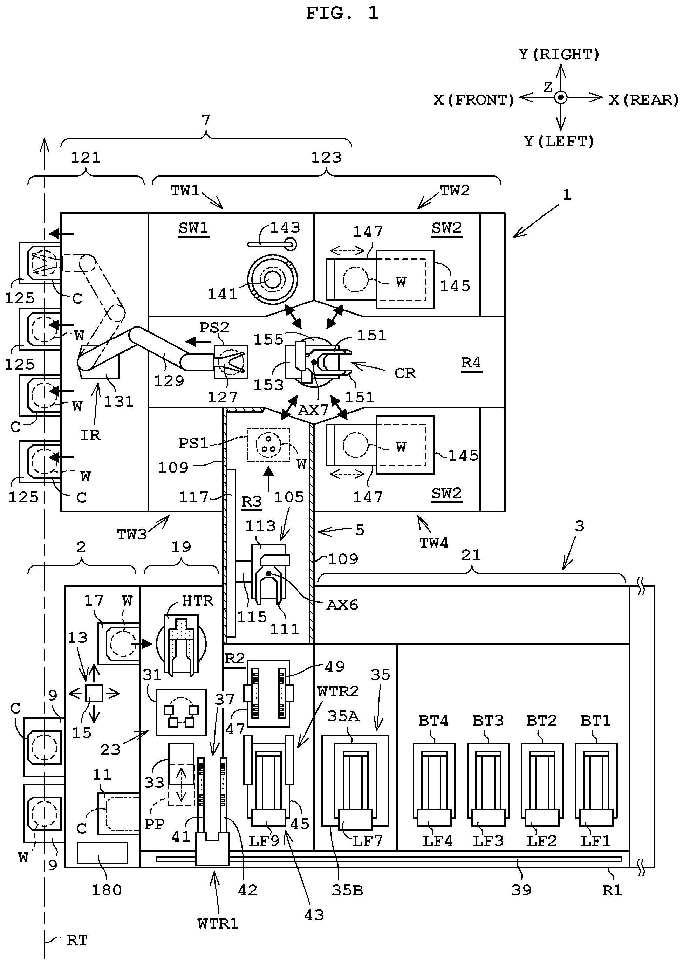

Hereinafter, a first embodiment of the present invention will be described with reference to the drawings. FIG. 1 is a plan view illustrating a schematic configuration of a substrate processing system 1 according to the first embodiment.

In the present specification, for convenience, a direction in which a transfer block 19 (described later) and a processing block 21 (described later) are arranged is referred to as "front-rear direction X". The front-rear direction X is horizontal. Of the front-rear direction X, for example, a direction from the processing block 21 toward the transfer block 19 is referred to as "front side". A direction opposite to the front side is referred to as "rear side". A horizontal direction perpendicular to the front-rear direction X is referred to as "width direction Y". One direction in the "width direction Y" is referred to as "right side" as appropriate. A direction opposite to the right side is referred to as "left side". A direction perpendicular to the horizontal direction is referred to as "vertical direction Z". In each drawing, front, rear, right, left, up, and down are appropriately shown for reference.

### <1. Overall Configuration>

Reference is made to FIG. 1. The substrate processing system 1 processes a substrate W. The substrate processing system 1 performs, for example, a chemical treatment, a cleaning treatment, and a drying treatment on the substrate W. The substrate processing system 1 performs batch processing to collectively process a plurality of (for example, 50 or 25) the substrates Wand single-wafer processing (single-substrate processing) to process the plurality of substrates W one by one. Therefore, the substrate processing system 1 is called a hybrid substrate processing system 1.

The substrate processing system 1 includes a stocker apparatus 2, a batch processing apparatus 3, a relay apparatus 5, and a single-wafer processing apparatus 7. The batch processing apparatus 3 collectively processes the plurality of substrates W. The single-wafer processing apparatus 7 processes the plurality of substrates W one by one. The single-wafer processing apparatus 7 is disposed on the right side of the batch processing apparatus 3 and is disposed apart from the batch processing apparatus 3. The relay apparatus 5 connects the batch processing apparatus 3 and the single-wafer processing apparatus 7.

### <2. Stoker Apparatus>

The stocker apparatus 2 accommodates at least one carrier C. The stocker apparatus 2 is adjacent to the front of the batch processing apparatus 3. The carrier C accommodates a plurality of (for example, 25) the substrates W in a horizontal attitude at predetermined intervals (for example, 10 mm). In the carrier C, the plurality of substrates W are arranged in the vertical direction Z or a thickness direction of each substrate W. Examples of the carrier C include, but are not limited to, a front opening unify pod (FOUP).

The stocker apparatus 2 includes a plurality of (for example, two) load ports 9. The two load ports 9 are disposed in the width direction Y In the present embodiment, the two load ports 9 are used for loading and unloading the carrier C. The stocker apparatus 2 also includes at least one storage shelf 11 and a carrier transport robot 13. The storage shelf 11 is a shelf for storing the carrier C. The carrier C is placed on the storage shelf 11.

The carrier transport robot 13 transports the carrier C among the two load ports 9, the storage shelf 11, and a placement shelf 17 to be described later. The carrier transport robot 13 includes a gripper 15 that grips a protrusion provided on an upper surface of the carrier C, for example. The carrier transport robot 13 can move the gripper 15 in the horizontal direction (front-rear direction X and width direction Y) and the vertical direction Z. The carrier transport robot 13 is driven by one or more electric motors. The carrier transport robot 13 may include a movable support that supports a lower surface of the carrier C instead of the gripper 15.

### <3. Batch Processing Apparatus>

The batch processing apparatus 3 includes the placement shelf 17, the transfer block 19, the processing block 21, and a batch transport region R1. The placement shelf 17 is adjacent to the front of the transfer block 19. The processing block 21 is disposed behind the transfer block 19 with an attitude changing region R2 to be described later therebetween. The batch transport region R1 extends rearward from the transfer block 19. The batch transport region R1 is adjacent to the left of the transfer block 19, the processing block 21, and the attitude changing region R2.

### <3-1. Transfer Block>

The transfer block 19 includes a substrate handling mechanism (robot) HTR and a first attitude changing mechanism 23. The substrate handling mechanism HTR is provided behind the placement shelf 17. The substrate handling mechanism HTR transports the plurality of (for example, 25) substrates W in the horizontal attitude between the carrier C placed on the placement shelf 17 and the first attitude changing mechanism 23.

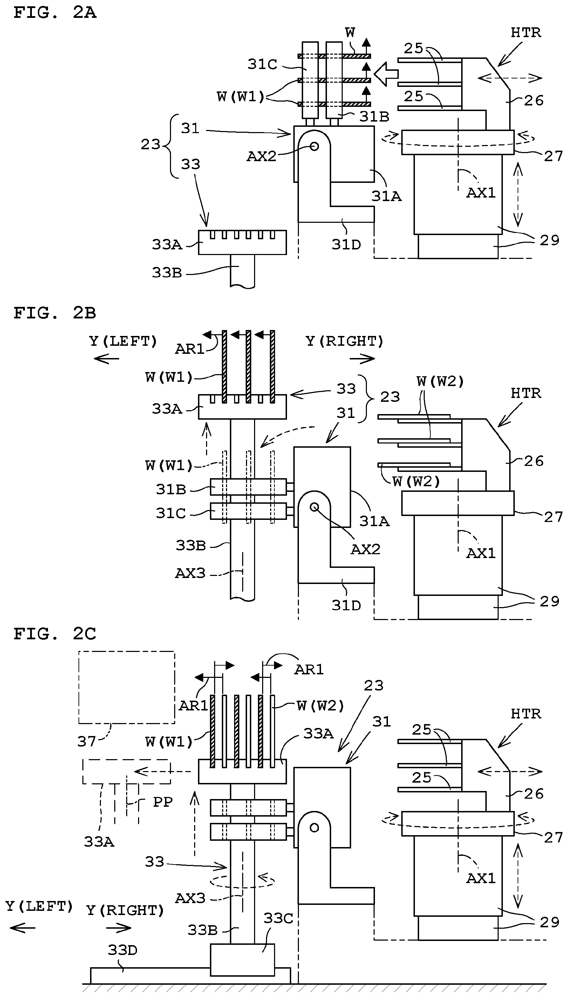

Reference is made to FIGS. 2A to 2C. The substrate handling mechanism HTR includes a plurality of (for example, 25) hands 25. Each of the hands 25 holds one substrate W. In FIGS. 2A to 2C, for convenience of illustration, the substrate handling mechanism HTR includes three hands 25. In addition, a pair of horizontal holders 31B and a pair of vertical holders 31C to be described later hold three substrates W. Moreover, a pusher 33A to be described later supports six substrates W.

The substrate handling mechanism HTR further includes a hand support 26, an advancing/retracting part 27, and a raising/lowering rotator 29. The hand support 26 supports the plurality of hands 25. The advancing/retracting part 27 advances and retracts the plurality of hands 25 using the hand support 26. The raising/lowering rotator 29 rotates the advancing/retracting part 27 about a vertical axis AX1 to change the direction of the hands 25. The raising/lowering rotator 29 is fixed to a floor surface. The advancing/retracting part 27 and the raising/lowering rotator 29 each include an electric motor. The substrate handling mechanism HTR may include a movable hand (not illustrated) for transporting only one substrate W, separately from the hands 25.

The first attitude changing mechanism 23 includes an attitude changer 31 and a pusher mechanism 33. The substrate handling mechanism HTR, the attitude changer 31, and the pusher mechanism 33 are disposed to the left side in this order.

The attitude changer 31 changes the plurality of (for example, 25) substrates W between the horizontal attitude and a vertical attitude. For example, the attitude changer 31 changes the plurality of substrates W received from the substrate handling mechanism HTR from the horizontal attitude to the vertical attitude. As illustrated in FIG. 2A, the attitude changer 31 includes a support base 31A, the pair of horizontal holders 31B, the pair of vertical holders 31C, and a rotation driver 31D. The pair of horizontal holders 31B and the pair of vertical holders 31C are provided on the support base 31A. When the substrates W are in the horizontal attitude, the pair of horizontal holders 31B supports the substrates W from below in contact with lower surfaces of the substrates W. When the substrates W are in the vertical attitude, the pair of vertical holders 31C holds the substrates W. The rotation driver 31D rotates the support base 31A about a horizontal axis AX2.

As illustrated in FIG. 2C, the pusher mechanism 33 includes the pusher 33A, a raising/lowering rotator 33B, a horizontal mover 33C, and a rail 33D. The pusher 33A holds respective lower portions of the plurality of (for example, 25 or 50) substrates W changed to the vertical attitude by the attitude changer 31. The raising/lowering rotator 33B raises and lowers the pusher 33A in the vertical direction Z. The raising/lowering rotator 33B also rotates the pusher 33A about a vertical axis AX3. As a result, the direction of a device surface of the substrate W indicated by an arrow AR1 can be set to any direction.

The horizontal mover 33C horizontally moves the pusher 33A and the raising/lowering rotator 33B along the rail 33D. The rail 33D extends in the width direction Y The rotation driver 31D, the raising/lowering rotator 33B, and the horizontal mover 33C each include an electric motor.

Here, an operation of the first attitude changing mechanism 23 will be described. For example, each of four batch processing tanks BT1 to BT4 to be described later of the processing block 21 collectively processes 50 substrates W corresponding to two carriers C. To this end, the pusher 33Aholds the 50 substrates W (W1, W2) that are changed in attitude by 25 substrates each. The 25 substrates W1 are referred to as a first substrate group. The 25 substrates W2 are referred to as a second substrate group. The 50 substrates W (W1, W2) are referred to as a processing substrate group. In a case where the substrates W1 and W2 are not particularly distinguished, the substrates W1 and the substrates W2 are described as the substrates W.

Reference is made to FIG. 2A. The attitude changer 31 receives the 25 substrates W1 from the substrate handling mechanism HTR. At this time, the 25 substrates W1 are in the horizontal attitude and arranged at a full pitch (for example, at an interval of 10 mm). The full pitch is also referred to as a normal pitch. The device surface of each substrate W1 faces upward. The device surface of the substrate W is a surface on which an electronic circuit is formed, and also includes a surface in the middle of forming the electronic circuit. The device surface is also referred to as "front surface" or "main surface". A back surface of the substrate W is a surface on which no electronic circuit is formed. A surface opposite to the device surface is the back surface.

Reference is made to FIG. 2B. The rotation driver 31D of the attitude changer 31 rotates the pair of horizontal holders 31B and the like by 90 degrees about the horizontal axis AX2 to change the 25 substrates W1 from the horizontal attitude to the vertical attitude. Thereafter, the pusher mechanism 33 raises the pusher 33A to receive the 25 substrates W1 from the attitude changer 31. Thereafter, the pusher mechanism 33 rotates the pusher 33A by 180 degrees about the vertical axis AX3. As a result, the direction of the device surfaces of the 25 substrates W1 is changed from the left to the right.

Thereafter, the attitude changer 31 receives the 25 substrates W2 from the substrate handling mechanism HTR, and changes the 25 substrates W2 from the horizontal attitude to the vertical attitude. Thereafter, the pusher mechanism 33 raises the pusher 33A holding the 25 substrates W1. As a result, the pusher 33A further receives the 25 substrates W2.

Reference is made to FIG. 2C. The pusher 33A holds the 50 substrates W (W1, W2). The 25 substrates W1 and the 25 substrates W2 are alternately disposed. The 50 substrates W are arranged at a half pitch (for example, at an interval of 5 mm). The half pitch is half the full pitch. The 50 substrates W are disposed in a face to face manner. Therefore, two device surfaces (or two back surfaces) of two adjacent substrates W1 and W2 face each other. Thereafter, the pusher mechanism 33 moves the pusher 33A holding the 50 substrates W to a substrate delivery position PP below a chuck 37 (described later) of a batch transport robot WTR1 (described later) along the rail 33D.

The attitude changer 31 of the first attitude changing mechanism 23 cannot vertically invert the plurality of substrates W in the vertical attitude. The placement shelf 17 corresponds to a first carrier placement shelf and a carrier placement shelf of the present invention.

### <3-2. Processing Block>

The processing block 21 includes the plurality of (for example, four) batch processing tanks BT1 to BT4 and a batch dryer 35. The four batch processing tanks BT1 to BT4 are disposed side by side in the front-rear direction X in which the batch processing apparatus 3 extends. Each of the four batch processing tanks BT1 to BT4 collectively immerses the plurality of (for example, 25 or 50) substrates W. Each of the four batch processing tanks BT1 to BT4 stores a treatment liquid (for example, chemical liquid or pure water) for immersing the plurality of substrates W.

The four batch processing tanks BT1 to BT4 include, for example, two chemical treatment tanks BT1 and BT3 and two cleaning treatment tanks BT2 and BT4. The chemical treatment tank BT1 and the cleaning treatment tank BT2 constitute one set, and the chemical treatment tank BT3 and the cleaning treatment tank BT4 constitute the other set. The combination of the chemical treatment tanks and the cleaning treatment tanks is not limited to this example. The number of batch processing tanks is not limited to 4, and only has to be 1 or more.

Each of the two chemical treatment tanks BT1 and BT3 performs an etching treatment using a chemical liquid. As the chemical liquid, for example, a phosphoric acid solution is used. The chemical liquid is heated to a preset temperature. A chemical liquid ejection pipe (not illustrated) is provided at an inner bottom of each of the chemical treatment tanks BT1 and BT3. Each of the chemical treatment tanks BT1 and BT3 stores the chemical liquid supplied from the chemical liquid ejection pipe. A gas supply pipe (not illustrated) may also be provided at the inner bottom of each of the chemical treatment tanks BT1 and BT3. The gas supply pipe supplies a foamed inert gas (for example, nitrogen gas) into the chemical liquid in the chemical treatment tank BT1, for example. For example, when the plurality of substrates W are immersed in the chemical liquid in the chemical treatment tank BT1, at least one of supplying the chemical liquid from the chemical liquid ejection pipe and supplying the foamed inert gas from the gas supply pipe may be performed to circulate the chemical liquid.

Each of the two cleaning treatment tanks BT2 and BT4 performs a cleaning treatment to wash away the chemical liquid adhering to the plurality of substrates W with a cleaning liquid (rinse liquid). As the cleaning liquid, for example, pure water such as deionized water (DIW) is used. Each of the cleaning treatment tanks BT2 and BT4 stores pure water supplied from a pure water ejection pipe (not illustrated).

Four lifters LF1 to LF4 are provided in the four batch processing tanks BT1 to BT4, respectively. For example, the lifter LF1 includes a plurality of (for example, 50) holding grooves (not illustrated) disposed in the width direction Y The lifter LF1 holds, for example, the 50 substrates W in the vertical attitude arranged at the half pitch having a predetermined interval (for example, an interval of 5 mm) by, for example, the 50 holding grooves. The lifter LF1 may include 51 or more holding grooves to hold the 50 substrates W.

The lifter LF1 can immerse the 50 substrates W in the chemical liquid in the batch processing tank BT1 while holding the 50 substrates W in the vertical attitude. The lifter LF1 raises and lowers the plurality of substrates W between a treatment position inside the batch processing tank BT1 and a delivery position above the batch processing tank BT1. The lifter LF1 includes an electric motor or an air cylinder for raising and lowering the plurality of substrates W. The other three lifters LF2 to LF4 are configured similarly to the lifter LF1.

The batch dryer 35 collectively dries the plurality of substrates W. The batch dryer 35 is used, for example, in a case where the single-wafer processing apparatus 7 cannot be used. The batch dryer 35 is provided in front of the four batch processing tanks BT1 to BT4. That is, the batch dryer 35 is provided between the transfer block 19 and the four batch processing tanks BT1 to BT4. The batch dryer 35 includes a lifter LF7.

### <3-3. Batch Transport Region>

The batch transport region R1 includes the batch transport robot WTR1. While holding the plurality of substrates W in the vertical attitude, the batch transport robot WTR1 transports the plurality of substrates W in the vertical attitude among the first attitude changing mechanism 23 (including the pusher mechanism 33), the four lifters LF1 to LF4, the relay apparatus 5 (a second attitude changing mechanism 43 to be described later), and the lifter LF7 of the batch dryer 35.

The substrate delivery position PP, the four lifters LF1 to LF4, the lifter LF7 of the batch dryer 35, and a standby lifter LF9 (described later) are arranged in a line in the front-rear direction X. Therefore, the batch transport robot WTR1 transports the plurality of substrates W in the vertical attitude in the front-rear direction X.

The batch transport robot WTR1 includes the chuck 37 and a guide rail 39. The chuck 37 includes two chuck members 41 and 42. The two chuck members 41 and 42 include, for example, 50 pairs of holding grooves for holding the 50 substrates W. Therefore, the first chuck member 41 includes 50 holding grooves, and the second chuck member 42 includes 50 holding grooves. The two chuck members 41 and 42 may include, for example, 51 or more pairs of holding grooves for holding the 50 substrates W. Each of the two chuck members 41 and 42 extends in the width direction Y The batch transport robot WTR1 opens and closes the two chuck members 41 and 42. The guide rail 39 extends in the front-rear direction X. The batch transport robot WTR1 moves the chuck 37 along the guide rail 39. The batch transport robot WTR1 is driven by an electric motor.

### <4. Relay Apparatus (Interface Apparatus)>

An outline of the relay apparatus 5 will be described. The relay apparatus 5 vertically inverts the plurality of substrates W in the vertical attitude subjected to first batch processing in any of the two chemical treatment tanks BT1 and BT3. The relay apparatus 5 changes the plurality of substrates W subjected to second batch processing in any of the two chemical treatment tanks BT1 and BT3 from the vertical attitude to the horizontal attitude. The relay apparatus 5 transports, for example, the plurality of substrates W changed to the horizontal attitude to the single-wafer processing apparatus 7. That is, the relay apparatus 5 transports the plurality of substrates W subjected to the second batch processing (chemical treatment and pure water cleaning treatment) from the batch processing apparatus 3 to the single-wafer processing apparatus 7.

The relay apparatus 5 will be described in detail. As illustrated in FIG. 1, the relay apparatus 5 includes the attitude changing region R2 and a relay region R3 disposed in the width direction Y The relay region R3 extends rightward from the attitude changing region R2. In the front-rear direction X, the attitude changing region R2 is disposed between the first attitude changing mechanism 23 of the transfer block 19 and the four batch processing tanks BT1 to BT4 of the processing block 21. A left-side portion of the relay region R3 is disposed between the transfer block 19 and the processing block 21.

### <4-1. Second Attitude Changing Mechanism>

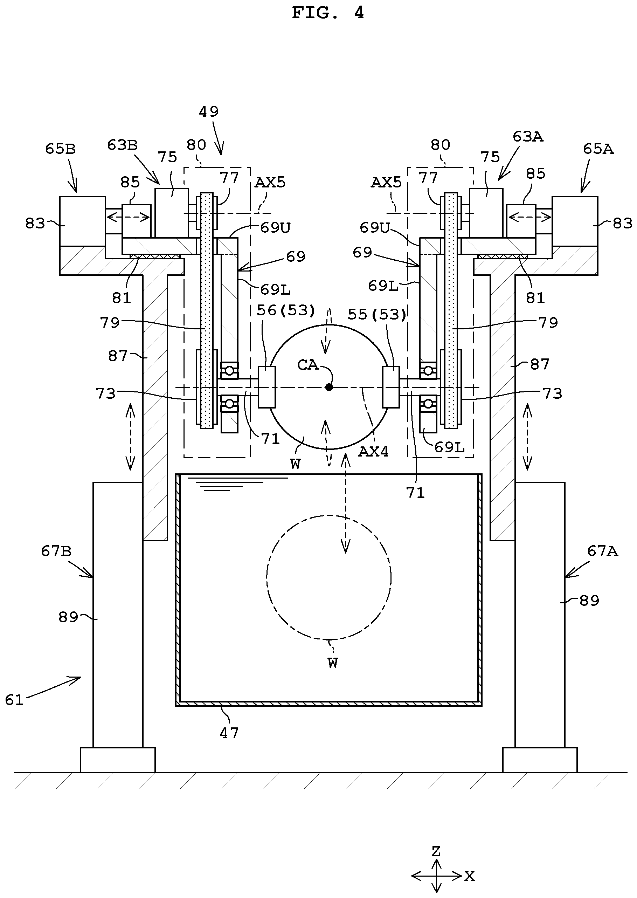

The second attitude changing mechanism 43 is provided in the attitude changing region R2. The second attitude changing mechanism 43 rotates the plurality of substrates W about a horizontal axis AX4 orthogonal to a central axis CA passing through the center of each substrate W (see FIG. 4). In other words, the second attitude changing mechanism 43 rotates the plurality of substrates W about the horizontal axis AX4 extending along the device surface (front surface or main surface) of each substrate W of the plurality of substrates W. As a result, the second attitude changing mechanism 43 has two functions. The first function is to vertically invert the plurality of substrates W in the vertical attitude. The second function is to change the plurality of substrates W from the vertical attitude to the horizontal attitude.

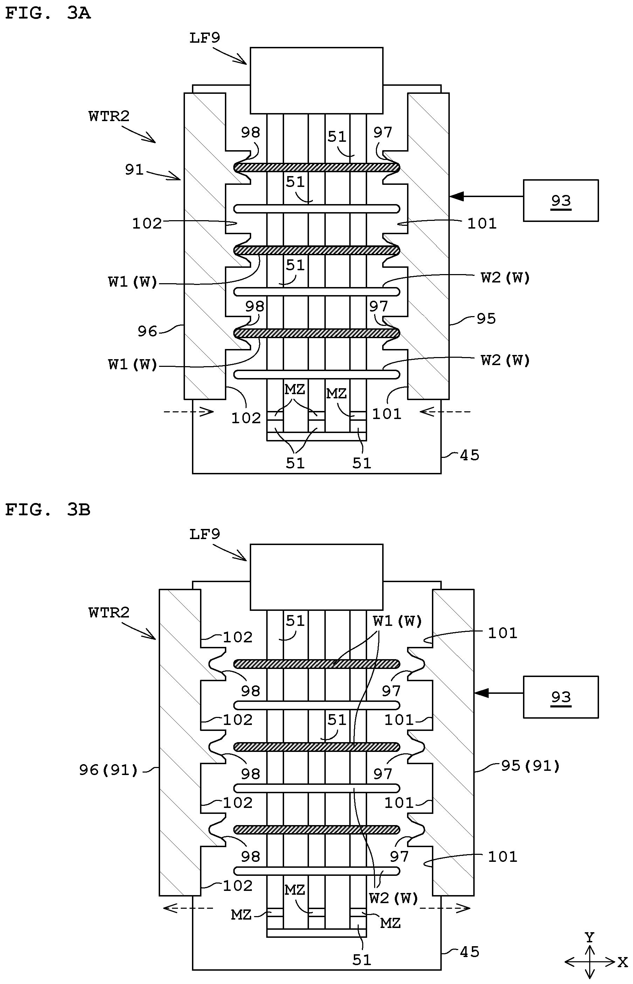

The second attitude changing mechanism 43 includes a standby tank 45, the standby lifter LF9, an attitude changing tank 47, an attitude changer 49, and a second batch transport robot WTR2. FIGS. 3A and 3B are plan views of the standby tank 45, the standby lifter LF9, and the batch transport robot WTR2. In FIGS. 3A and 3B, two chuck members 95 and 96 to be described later of the batch transport robot WTR2 are shown in cross sectional views. In FIGS. 3A and 3B, for convenience of illustration, the lifter LF9 holds six substrates W.

The standby tank 45 stores an immersion liquid for immersing the plurality of substrates W. Pure water (for example, DIW) is used as the immersion liquid. The pure water is supplied from a pure water ejection pipe (not illustrated).

The standby lifter LF9 receives the plurality of substrates W from the batch transport robot WTR1 and holds the plurality of substrates W in the vertical attitude. The standby lifter LF9 includes a plurality of (for example, three) support members 51 extending in the width direction Y Each of the plurality of support members 51 includes a plurality of holding grooves MZ for holding the plurality of substrates W. The number of holding grooves MZ is set to be larger than the number of substrates W collectively processed in the batch processing tanks BT1 to BT4. In this case, the number of substrates W is the number obtained when there is no missing portion in the row of the substrates W. For example, in a case where the 50 substrates W having no missing portion are collectively processed in the batch processing tanks BT1 to BT4, the number of holding grooves MZ is 51 or more. The standby lifter LF9 includes an electric motor or an air cylinder for raising and lowering the plurality of support members 51.

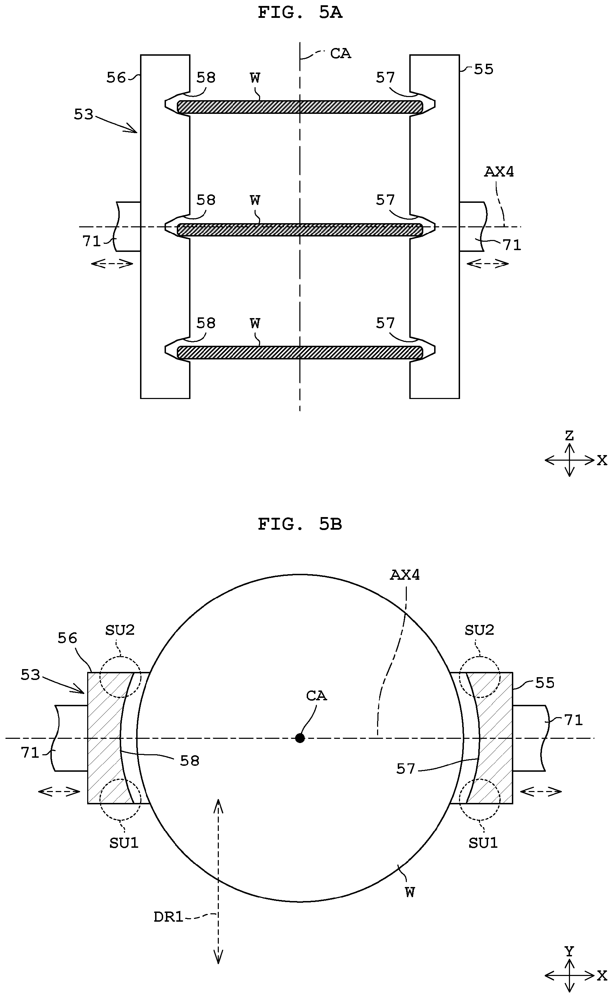

FIG. 4 is a longitudinal sectional view of the attitude changing tank 47 and the attitude changer 49 as viewed from the front. FIG. 5A is a front view illustrating a state in which a reversing chuck 53 in an open state supports the plurality of substrates W in the horizontal attitude. In FIG. 5A, for convenience of illustration, the reversing chuck 53 supports three substrates W. FIG. 5B is a cross sectional view illustrating a state in which a pair of holding grooves 57 and 58 of the reversing chuck 53 in an open state supports one substrate W in the horizontal attitude.

Reference is made to FIG. 4. The attitude changing tank 47 stores an immersion liquid for immersing the plurality of substrates W. Pure water (for example, DIW) is used as the immersion liquid. The pure water is supplied from a pure water ejection pipe (not illustrated). The attitude changing tank 47 may store a different type of immersion liquid from the standby tank 45.

The attitude changer 49 includes the reversing chuck 53 that holds the plurality of (for example, 25) substrates W. The attitude changer 49 rotates the reversing chuck 53 about the horizontal axis AX4. The reversing chuck 53 includes two chuck members 55 and 56. The two chuck members 55 and 56 are openable and closable along the horizontal axis AX4. The horizontal axis AX4 extends in the front-rear direction X. As illustrated in FIG. 5A, the two chuck members 55 and 56 include a plurality of pairs (for example, 25 pairs) of the holding grooves 57 and 58. That is, the first chuck member 55 is provided with a plurality of (for example, 25) the holding grooves 57. The second chuck member 56 is provided with a plurality of (for example, 25) the holding grooves 58. The holding grooves 57 and 58 of each pair face each other.

Each of the holding grooves 57 and 58 is formed in a V shape such that its depth becomes narrower in the thickness direction of the substrate W. Each of the holding grooves 57 and 58 is formed in an arc shape in a direction along the device surface of the substrate W. The arc shape is a shape along an outer edge of the substrate W.

Directions DR1 illustrated in FIG. 5B are directions orthogonal to the direction in which the two chuck members 55 and 56 are opened and closed, and along the device surface of one substrate W to be accommodated. The directions DR1 are referred to as substrate in/out directions. The directions DR1 are directions in which one substrate W is accommodated in each pair of holding grooves 57 and 58 and one substrate W is taken out from each pair of holding grooves 57 and 58 when the two chuck members 55 and 56 are in an open state. Each of the plurality of pairs of holding grooves 57 and 58 includes a first support portion SU1 that stops movement of one substrate W to be accommodated in a predetermined direction out of the directions DR1 and a second support portion SU2 that stops movement of the one substrate W to be accommodated in a direction opposite to the predetermined direction.

The attitude changer 49 includes a drive mechanism 61 in addition to the reversing chuck 53. The drive mechanism 61 includes rotators 63A and 63B, opening/closing parts 65A and 65B, and raising/lowering parts 67A and 67B. The rotators 63A and 63B rotate the reversing chuck 53 about the horizontal axis AX4. The opening/closing parts 65A and 65B open and close the reversing chuck 53 along the horizontal axis AX4. The raising/lowering parts 67A and 67B raise and lower the reversing chuck 53 in the vertical direction Z.

The rotator 63A, the opening/closing part 65A, and the raising/lowering part 67A drive the first chuck member 55. On the other hand, the rotator 63B, the opening/closing part 65B, and the raising/lowering part 67B drive the second chuck member 56. The rotator 63A, the opening/closing part 65A, and the raising/lowering part 67A are configured substantially similarly to the rotator 63B, the opening/closing part 65B, and the raising/lowering part 67B. Therefore, the rotator 63A, the opening/closing part 65A, and the raising/lowering part 67A will be described as a representative example.

The rotator 63A includes an arm member 69, a rotating shaft 71, a pulley 73, an electric motor 75, a pulley 77, a belt 79, and a case 80.

The arm member 69 supports the chuck member 55 rotatably about the horizontal axis AX4. The arm member 69 includes a vertical member 69L extending in the vertical direction Z and a horizontal member 69U extending in the horizontal direction (front-rear direction X) from an upper end of the vertical member 69L. The pulley 73 is connected to a back surface of the chuck member 55 through the rotating shaft 71. Therefore, the rotating shaft 71 extends in the front-rear direction X. The rotating shaft 71 passes through the vertical member 69L of the arm member 69.

The electric motor 75 is provided on an upper surface of the horizontal member 69U of the arm member 69. The pulley 77 is connected to an output shaft of the electric motor 75. The belt 79 is put on (wound around) the two pulleys 73 and 77. When the electric motor 75 rotates the pulley 77 about a horizontal axis AX5, the pulley 73 and the chuck member 55 are rotated about the horizontal axis AX4. The horizontal axis AX5 extends in the front-rear direction X. The case 80 is configured such that the immersion liquid does not enter the case 80 when the substrates W are immersed in the immersion liquid in the attitude changing tank 47.

The opening/closing part 65A includes a guide rail 81, an opening/closing driver 83, and a moving piece 85. The guide rail 81 and the opening/closing driver 83 are provided on an upper surface of a raising/lowering member 87 to be described later. The guide rail 81 extends in the front-rear direction X in which the two chuck members 55 and 56 are opened and closed. The horizontal member 69U of the arm member 69 is connected to the raising/lowering member 87 through the guide rail 81, and is movable in the front-rear direction X along the guide rail 81.

The opening/closing driver 83 includes, for example, an air cylinder, but may include an electric motor. The opening/closing driver 83 moves the moving piece 85 in the front-rear direction X. The moving piece 85 is fixed to the horizontal member 69U. As a result, when the opening/closing driver 83 pushes the moving piece 85, the chuck member 55 is pushed toward the substrates W through the arm member 69. When the opening/closing driver 83 pulls the moving piece 85, the chuck member 55 is separated from the substrates W through the arm member 69.

The raising/lowering part 67A includes the raising/lowering member 87 and a raising/lowering driver 89. The raising/lowering driver 89 raises and lowers the raising/lowering member 87 in the vertical direction Z. The raising/lowering driver 89 includes, for example, an electric motor, a screw shaft, a guide rail, and a slider (none of which are illustrated). The raising/lowering driver 89 may include an air cylinder instead of the electric motor or the like.

Reference is made to FIGS. 3A and 3B. The second batch transport robot WTR2 transports the plurality of (for example, 25) substrates W between the standby lifter LF9 and the reversing chuck 53 of the attitude changer 49. For example, it is assumed that the standby lifter LF9 holds the 50 substrates W (W1, W2) in which the 25 substrates W1 and the 25 substrates W2 are alternately disposed. The second batch transport robot WTR2 can selectively extract, for example, the 25 substrates W1 or the 25 substrates W2 from the 50 substrates W.

The second batch transport robot WTR2 includes an extraction chuck 91 and a drive mechanism 93. The extraction chuck 91 is movable in the width direction Y and is openable and closable. The extraction chuck 91 includes the pair of chuck members 95 and 96. The pair of chuck members 95 and 96 includes a plurality of pairs (for example, 25 pairs) of holding grooves 97 and 98 and a plurality of pairs (for example, 26 pairs) of passing grooves 101 and 102. The 25 pairs of holding grooves 97 and 98 and the 26 pairs of passing grooves 101 and 102 are alternately disposed.

That is, the first chuck member 95 is provided with the 25 holding grooves 97 and the 26 passing grooves 101 that are alternately disposed. The second chuck member 96 is provided with the 25 holding grooves 98 and the 26 passing grooves 102 that are alternately disposed. The holding grooves 97 and 98 of each pair face each other, and the passing grooves 101 and 102 of each pair face each other.

The drive mechanism 93 moves the extraction chuck 91 in the width direction Y The drive mechanism 93 opens and closes the extraction chuck 91 by moving the two chuck members 95 and 96 in the front-rear direction X. FIG. 3A illustrates a closed state of the extraction chuck 91, and FIG. 3B illustrates an open state of the extraction chuck 91. When the extraction chuck 91 is in an open state, the two chuck members 95 and 96 are opened larger than the diameter of each substrate W. The drive mechanism 93 includes, for example, at least one of an electric motor and an air cylinder.

### <4-2: Substrate Transport Robot>

Reference is made to FIG. 1. A substrate transport robot 105 and a substrate placement part PS1 are provided in the relay region R3. The substrate transport robot 105 uses a relay hand 111 to transport the plurality of substrates W changed to the horizontal attitude by the second attitude changing mechanism 43. An external atmosphere in the relay region R3 is blocked by a housing 109.

The substrate transport robot 105 includes the relay hand 111, an advancing/retracting part 113, a rotator 115, and a horizontal mover 117. The substrate transport robot 105 corresponds to a first horizontal substrate transport robot of the present invention. The relay hand 111 corresponds to a first hand of the present invention.

The relay hand 111 holds one substrate W in the horizontal attitude and is movable. The advancing/retracting part 113 advances and retracts the relay hand 111. The rotator 115 rotates the relay hand 111 and the advancing/retracting part 113 about a vertical axis AX6 set in the rotator 115. The horizontal mover 117 moves the relay hand 111, the advancing/retracting part 113, and the rotator 115 in the width direction Y The advancing/retracting part 113, the rotator 115, and the horizontal mover 117 are each driven by an electric motor. One or more substrates W can be placed on the substrate placement part PS1.

### <5. Single-Wafer Processing Apparatus>

Reference is made to FIG. 1. The single-wafer processing apparatus 7 performs preset single-wafer processing on the plurality of substrates W received from the relay apparatus 5 one by one, and transports the plurality of substrates W subjected to the single-wafer processing to the carrier C placed on any one of four placement shelves 125.

The single-wafer processing apparatus 7 includes an indexer block 121 and a processing block 123. The indexer block 121 includes the plurality of (for example, four) placement shelves 125 and an indexer robot IR. The four placement shelves 125 are disposed in the width direction Y The four placement shelves 125 are disposed in front of the indexer robot IR. The carrier C is placed on each placement shelf 125.

The indexer robot IR includes a hand 127, an articulated arm 129, and a raising/lowering base 131. The hand 127 holds one substrate W in the horizontal attitude. The articulated arm 129 includes, for example, a selective compliance assembly robot arm (SCARA). A proximal end of the articulated arm 129 is attached to the raising/lowering base 131. A distal end of the articulated arm 129 is connected to the hand 127. The articulated arm 129 and the raising/lowering base 131 each include an electric motor.

The indexer robot IR transports the substrate W between the four carriers C placed on the four placement shelves 125 and a substrate placement part PS2 to be described later. For example, the indexer robot IR receives the substrate W from the substrate placement part PS2 to be described later, and transports the substrate W to the carrier C placed on any one of the four placement shelves 125.

The indexer robot corresponds to a second horizontal substrate transport robot of the present invention. The hand 127 corresponds to a second hand of the present invention. The placement shelf 125 corresponds to a second carrier placement shelf of the present invention.

The processing block 123 is adjacent to the rear of the indexer block 121. The processing block 123 includes a substrate transport region R4 and, for example, four towers TW1 to TW4. The substrate transport region R4 extends rearward from the indexer block 121. That is, the substrate transport region R4 extends in the front-rear direction X. The four towers TW1 to TW4 are provided along the substrate transport region R4. The two towers TW1 and TW2 are disposed facing the two towers TW3 and TW4 with the substrate transport region R4 therebetween. The tower TW2 is provided at the back of the tower TW1. The tower TW4 is provided at the back of the tower TW3.

The tower TW1 includes three single-wafer processing chambers SW1 disposed in the vertical direction Z. The tower TW3 includes two single-wafer processing chambers SW1 disposed in the vertical direction Z. In the tower TW3, the substrate placement part PS 1 of the relay apparatus 5 is disposed between the two single-wafer processing chambers SW1. Each of the two towers TW2 and TW4 includes three single-wafer processing chambers SW2 disposed in the vertical direction Z. Each of the 11 single-wafer processing chambers SW1 and SW2 processes one substrate W in the horizontal attitude.

The number of single-wafer processing chambers SW1 and SW2 is not limited to 11. In addition, the number of single-wafer processing chambers SW1 is not limited to 5, and only has to be 1 or more. Furthermore, the number of single-wafer processing chambers SW2 is not limited to 6, and only has to be 1 or more.

Each single-wafer processing chamber SW1 includes, for example, a holding rotator 141 and a nozzle 143. The holding rotator 141 includes a spin chuck that holds one substrate W in the horizontal attitude and an electric motor that rotates the spin chuck about a vertical axis passing through the center of the substrate W. The nozzle 143 supplies a treatment liquid onto the substrate W held by the holding rotator 141. As the treatment liquid, for example, pure water (for example, DIW) and isopropyl alcohol (IPA) are used. In the single-wafer processing chamber SW1, for example, after a cleaning treatment with pure water is performed on the substrate W, a liquid film of IPA is formed on an upper surface of the substrate W.

Each of the single-wafer processing chambers SW2 performs, for example, a drying treatment with a supercritical fluid. As the fluid, for example, carbon dioxide is used. In a case where the fluid is carbon dioxide, a supercritical state is obtained when a critical temperature is 31°C and a critical pressure is 7.38 MPa. By performing the drying treatment with the supercritical fluid, it is possible to make pattern collapse in the substrate W less likely to occur.

The single-wafer processing chamber SW2 includes a chamber body (container) 145, a support tray 147, and a lid. The chamber body 145 includes a treatment space provided inside, an opening for inserting the substrate W into the treatment space, a supply port, and an exhaust port. The substrate W is accommodated in the treatment space while being supported by the support tray 147. The lid closes the opening of the chamber body 145. For example, each single-wafer processing chamber SW2 brings the fluid into the supercritical state, and supplies the supercritical fluid from the supply port to the treatment space in the chamber body 145. The drying treatment is performed on one substrate W by the supercritical fluid supplied to the treatment space.

In the substrate transport region R4, a center robot CR and the substrate placement part PS2 are provided. The substrate placement part PS2 is disposed between the indexer robot IR and the center robot CR. One or more substrates W are placed on the substrate placement part PS2.

The center robot CR includes, for example, two hands 151, an advancing/retracting part 153, and a raising/lowering rotator 155. Each of the two hands 151 holds one substrate W in the horizontal attitude. The advancing/retracting part 153 individually advances and retracts the two hands 151. The raising/lowering rotator 155 raises and lowers the two hands 151 and the advancing/retracting part 153. The raising/lowering rotator 155 rotates the two hands 151 and the advancing/retracting part 153 about a vertical axis AX7 to change the direction of the two hands 151. The advancing/retracting part 153 and the raising/lowering rotator 155 each include an electric motor.

The center robot CR transports one substrate W in the horizontal attitude among the substrate placement parts PS1 and PS2 and the 11 single-wafer processing chambers SW1 and SW2, for example. For example, the center robot CR receives one substrate transported by the substrate transport robot 105 of the relay apparatus 5, and transports the received one substrate W to any of the five single-wafer processing chambers SW1.

### <6. Controller>

The substrate processing system 1 includes a controller 180 (see FIG. 1) and a storage (not illustrated). The controller 180 controls each component of the substrate processing system 1. That is, the controller 180 controls each component of the batch processing apparatus 3, each component of the relay apparatus 5, and each component of the single-wafer processing apparatus 7. The controller 180 includes one or more processors such as a central processing unit (CPU). The storage includes, for example, at least one of a read-only memory (ROM), a random-access memory (RAM), and a hard disk. The storage stores a computer program necessary for controlling each component of the substrate processing system 1.

### <7. Operation of Substrate Processing System>

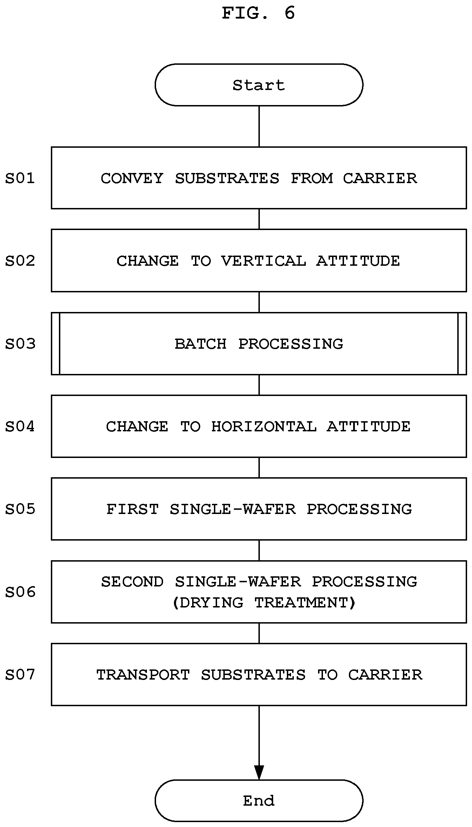

Next, an operation of the substrate processing system 1 will be described with reference to a flowchart of FIG. 6.

### [Step S01] Take Out Substrates from Carrier

Reference is made to FIG. 1. An external transport robot (not illustrated) transports the two carriers C to the two load ports 9. The carrier transport robot 13 of the stocker apparatus 2 transports the first carrier C from the load port 9 to the placement shelf 17. At this time, the first carrier C accommodates the 25 unprocessed substrates W1. The external transport robot transports the carriers C along a transport path RT illustrated in FIG. 1.

Thereafter, the substrate handling mechanism HTR of the batch processing apparatus 3 transports the 25 substrates W1 (first substrate group) in the horizontal attitude received from the first carrier C placed on the placement shelf 17, to the attitude changer 31 of the first attitude changing mechanism 23. That is, the substrate handling mechanism HTR takes out the 25 substrates W1 from the first carrier C placed on the placement shelf 17, and transports the taken-out 25 substrates W1 to the attitude changer 31 in the horizontal attitude.

Thereafter, the carrier transport robot 13 transports the first carrier C (empty carrier) from which the 25 substrates W1 have been taken out, from the placement shelf 17 to the load port 9. Thereafter, the carrier transport robot 13 transports the second carrier C from the load port 9 to the placement shelf 17. At this time, the second carrier C accommodates the 25 unprocessed substrates W2. Thereafter, the substrate handling mechanism HTR transports the 25 substrates W2 (second substrate group) in the horizontal attitude received from the second carrier C placed on the placement shelf 17, to the attitude changer 31 of the first attitude changing mechanism 23.

Thereafter, the carrier transport robot 13 transports the second carrier C (empty carrier) from which the 25 substrates W2 have been taken out, from the placement shelf 17 to the load port 9. The external transport robot sequentially transports the two carriers C (two empty carriers) from the load ports 9 to any two of the four placement shelves 125 of the single-wafer processing apparatus 7.

### [Step S02] Change to Vertical Attitude

The first attitude changing mechanism 23 forms the 50 substrates W1 and W2 (processing substrate group) in which the 25 substrates W1 and the 25 substrates W2 are alternately disposed, and all the device surfaces of the 25 substrates W1 and all the device surfaces of the 25 substrates W2 face each other. The first attitude changing mechanism 23 further changes the 50 substrates W1 and W2 from the horizontal attitude to the vertical attitude. The 50 substrates W1 and W2 are hereinafter referred to as "50 substrates W" as appropriate.

Specifically, as illustrated in FIGS. 2A to 2C, the attitude changer 31 changes the 25 substrates W1 from the horizontal attitude to the vertical attitude, and changes the 25 substrates W2 from the horizontal attitude to the vertical attitude. The pusher 33A of the pusher mechanism 33 holds in the vertical attitude the 50 substrates W in which the 25 substrates W1 and the 25 substrates W2 are alternately disposed. Thereafter, the pusher mechanism 33 transports the 50 substrates W to the substrate delivery position PP.

### [Step S03] Batch Processing

In the present embodiment, the batch processing (chemical treatment) performed collectively on the 50 substrates W is divided into two times of the first half and the latter half. Furthermore, a vertical inversion operation is performed on the 50 substrates W between the first batch processing and the second batch processing. This reduces processing variations in each substrate W occurring between the upper half and the lower half of the substrate. The vertical inversion operation is performed separately for the 25 substrates W1 and the 25 substrates W2.

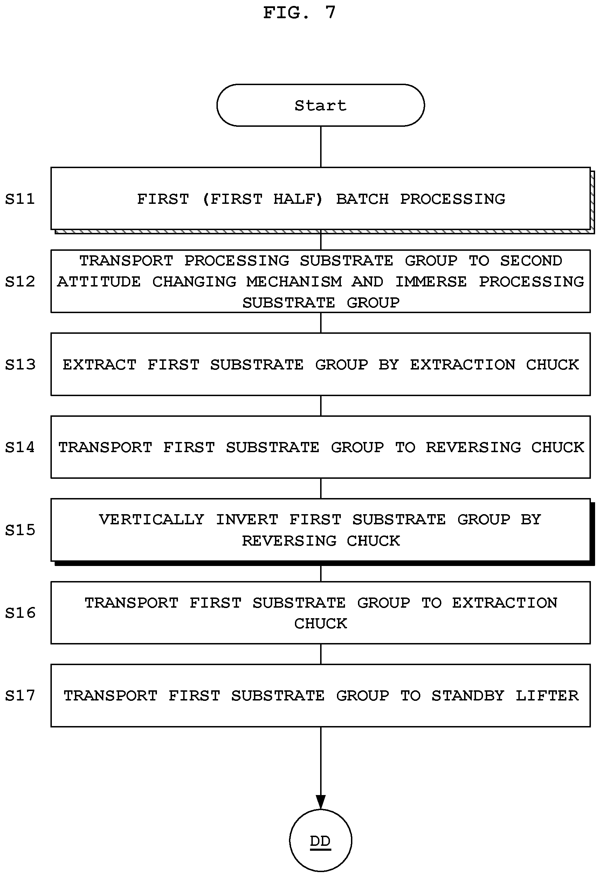

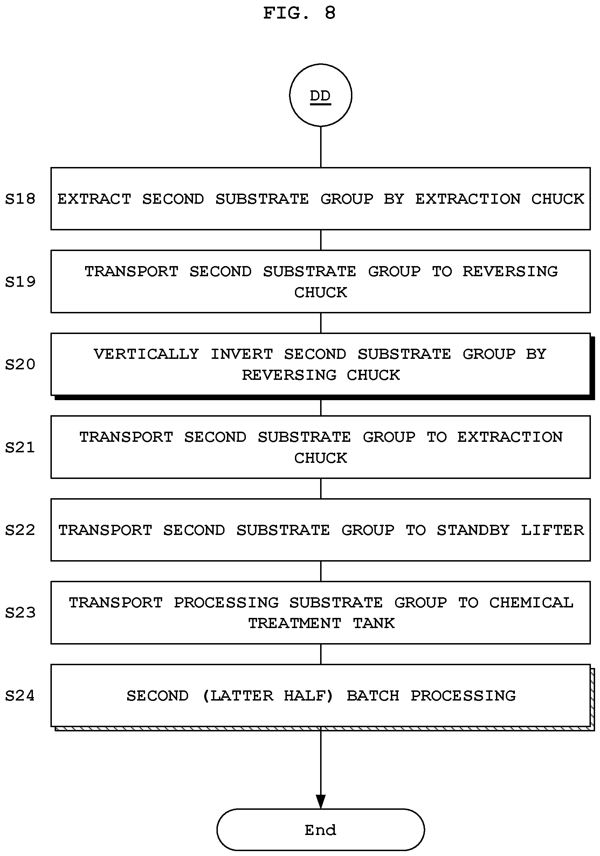

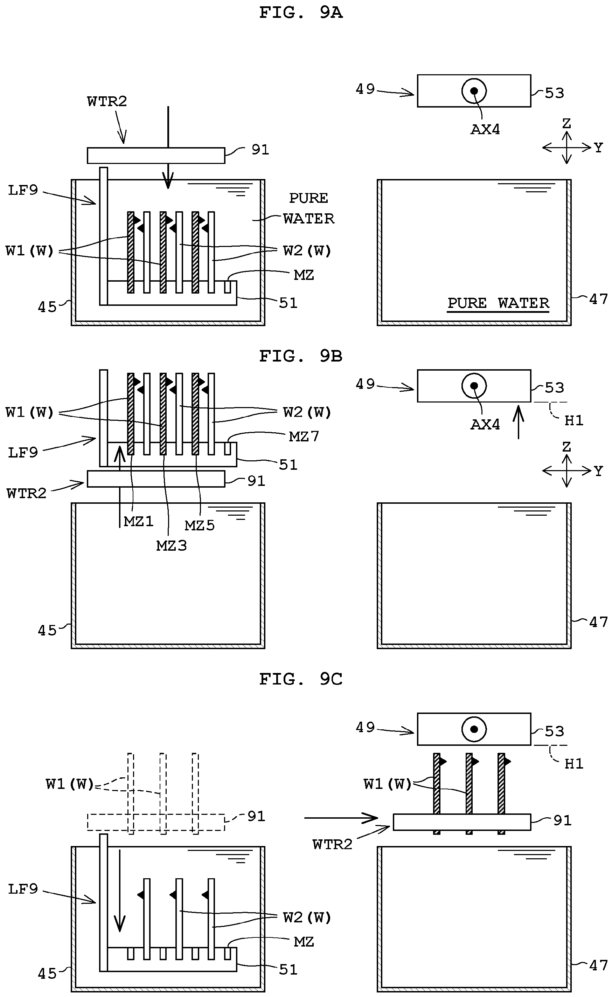

Next, a specific operation of the batch processing in step S03 will be described with reference to FIGS. 7 and 8. Steps S13 to S17 illustrated in FIG. 7 are the description of an operation on the 25 substrates W1 as the first substrate group. Steps S18 to S22 illustrated in FIG. 8 are the description of an operation on the 25 substrates W2 as the second substrate group. For example, a black triangle mark illustrated in FIG. 9A indicates the device surface (front surface or main surface) of the substrate W and its direction.

### [Step S11] First Batch Processing

The batch transport robot WTR1 receives the 50 substrates W in the vertical attitude from the pusher mechanism 33 at the substrate delivery position PP, and transports the 50 substrates W to one of the two lifters LF1 and LF3 of the two chemical treatment tanks BT1 and BT3.

For example, the batch transport robot WTR1 transports the 50 substrates W (processing substrate group) in the vertical attitude to the lifter LF1. The lifter LF1 receives the 50 substrates W at a position above the chemical treatment tank BT1. The lifter LF1 immerses the 50 substrates W in the phosphoric acid solution that is the chemical liquid in the chemical treatment tank BT1. As a result, the first batch processing (etching treatment) is performed. The first batch processing is performed until half (for example, two hours) of a normal processing time elapses. After the first batch processing, the lifter LF1 lifts the 50 substrates W from the phosphoric acid solution in the chemical treatment tank BT1. In a case where the 50 substrates W are transported to the lifter LF3 of the other chemical treatment tank BT3, the same treatment as in the chemical treatment tank BT1 is performed.

Thereafter, the batch transport robot WTR1 receives the 50 substrates W in the vertical attitude, for example, from the lifter LF1, and transports the 50 substrates W to the lifter LF2 of the cleaning treatment tank BT2. The lifter LF2 receives the 50 substrates W at a position above the cleaning treatment tank BT2. The lifter LF2 immerses the 50 substrates W in the pure water in the cleaning treatment tank BT2. As a result, a cleaning treatment (batch processing) is performed.

In a case where the batch transport robot WTR1 receives the 50 substrates W in the vertical attitude from the lifter LF3, the batch transport robot WTR1 transports the 50 substrates W to the lifter LF4 of the cleaning treatment tank BT4. The lifter LF4 immerses the 50 substrates W in the pure water in the cleaning treatment tank BT4.

### [Step S12] Transport Processing Substrate Group to Second Attitude Changing Mechanism and Immerse Processing Substrate Group

Thereafter, the batch transport robot WTR1 receives the 50 substrates W subjected to the cleaning treatment in one of the two batch processing tanks BT2 and BT4. That is, the batch transport robot WTR1 receives the 50 substrates W subjected to the cleaning treatment from one of the two lifters LF2 and LF4. When the 50 substrates W are transported, for example, the lifter LF2 lifts the 50 substrates W from the pure water in the cleaning treatment tank BT2. Thereafter, the batch transport robot WTR1 transports the 50 substrates W (processing substrate group) subjected to the first batch processing (etching treatment and the like) to the second attitude changing mechanism 43.

When the batch transport robot WTR1 moves the 50 substrates W to a position above the standby tank 45 and the standby lifter LF9 of the second attitude changing mechanism 43, the standby lifter LF9 raises the support members 51 to hold the 50 substrates W held by the batch transport robot WTR1 from below. Thereafter, the chuck 37 of the batch transport robot WTR1 is opened, so that the 50 substrates W are delivered to the standby lifter LF9. Thereafter, as illustrated in FIG. 9A, the standby lifter LF9 immerses the 50 substrates W in the pure water in the standby tank 45 in order to prevent drying of the substrates W.

### [Step S13] Extract First Substrate Group by Extraction Chuck

Reference is made to FIG. 9B. Thereafter, the standby lifter LF9 raises the 50 substrates W to lift the 50 substrates W from the pure water in the standby tank 45. The standby lifter LF9 also raises the 50 substrates W to a position higher than the extraction chuck 91 of the batch transport robot WTR2. At this time, the extraction chuck 91 is in an open state. Therefore, the 50 substrates W ascend between the two chuck members 95 and 96 of the extraction chuck 91.

Thereafter, the batch transport robot WTR2 moves the extraction chuck 91 to a preset position in the arrangement direction (width direction Y) of the 50 substrates W to extract the 25 substrates W1 (first substrate group or odd-numbered substrate group). Thereafter, the batch transport robot WTR2 brings the two chuck members 95 and 96 close to each other to close the extraction chuck 91. The reversing chuck 53 of the attitude changer 49 is raised to an upper position H1.

Reference is made to FIG. 9C. Thereafter, the standby lifter LF9 lowers the support members 51. As a result, the extraction chuck 91 of the batch transport robot WTR2 extracts the 25 substrates W1 from the 50 substrates W (W1, W2). Specifically, the 25 pairs of holding grooves 97 and 98 of the extraction chuck 91 hold the 25 substrates W1. The 26 pairs of passing grooves 101 and 102 of the extraction chuck 91 allow the 25 substrates W2 to pass therethrough. Therefore, the 25 substrates W1 are held by the extraction chuck 91, and the 25 substrates W2 are left in the standby lifter LF9. Thereafter, the standby lifter LF9 immerses the 25 substrates W2 in the pure water in the standby tank 45 in order to prevent drying of the substrates W2.

### [Step S14] Transport First Substrate Group to Reversing Chuck

Thereafter, the batch transport robot WTR2 advances the 25 substrates W1 held by the extraction chuck 91 to a preset delivery position below the reversing chuck 53 (or above the attitude changing tank 47).

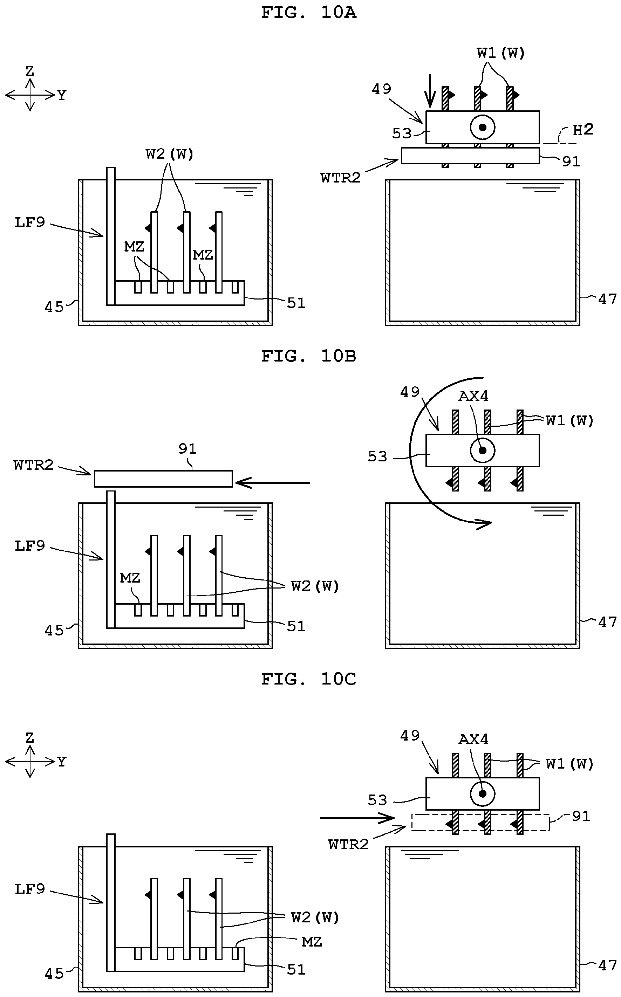

Reference is made to FIG. 10A. Thereafter, the raising/lowering parts 67A and 67B (FIG. 4) of the attitude changer 49 lower the reversing chuck 53 to a delivery height position H2 with the 25 substrates W1 being respectively accommodated in the 25 pairs of holding grooves 57 and 58. Thereafter, the opening/closing parts 65A and 65B (FIG. 4) of the attitude changer 49 bring the two chuck members 55 and 56 of the reversing chuck 53 close to each other to close the reversing chuck 53. As a result, the reversing chuck 53 holds the 25 substrates W1.

Reference is made to FIG. 10B. Thereafter, the batch transport robot WTR2 moves the two chuck members 95 and 96 away from each other to open the extraction chuck 91. Thereafter, the batch transport robot WTR2 retracts the extraction chuck 91 in the width direction Y to a position above the standby tank 45.

### [Step S15] Vertically Invert First Substrate Group by Reversing Chuck

Thereafter, the attitude changer 49 rotates the 25 substrates W1 subjected to the first batch processing about the horizontal axis AX4. As a result, the 25 substrates W1 in the vertical attitude are vertically inverted. Specifically, by rotating the two electric motors 75 of the rotators 63A and 63B illustrated in FIG. 4, the two chuck members 55 and 56 of the reversing chuck 53 are rotated by 180 degrees about the horizontal axis AX4. As a result, the 25 substrates W1 held by the reversing chuck 53 are rotated by 180 degrees. The vertical inversion operation may be performed in a state where the 25 substrates W are immersed in the pure water in the attitude changing tank 47. The attitude changer 49 may immerse the 25 substrates W1 held by the chuck 53 in the pure water in the attitude changing tank 47 in order to prevent drying of the substrates W1 at least either before performing the vertical inversion operation or after performing the vertical inversion operation.

### [Step S16] Transport First Substrate Group to Extraction Chuck

Reference is made to FIG. 10C. After the vertical inversion operation on the 25 substrates W1 (first substrate group), the batch transport robot WTR2 advances the extraction chuck 91 to the preset delivery position below the reversing chuck 53. At this time, the extraction chuck 91 is in an open state. Even when the extraction chuck 91 in the open state moves in the width direction Y, the extraction chuck 91 does not interfere with the 25 substrates W1 held by the reversing chuck 53.

Thereafter, the batch transport robot WTR2 causes the extraction chuck 91 to hold the 25 substrates W1 from below by closing the extraction chuck 91. Thereafter, the attitude changer 49 moves the two chuck members 55 and 56 of the reversing chuck 53 away from each other to open the reversing chuck 53. As a result, the 25 substrates W1 are held only by the extraction chuck 91.

### [Step S17] Transport First Substrate Group to Standby Lifter

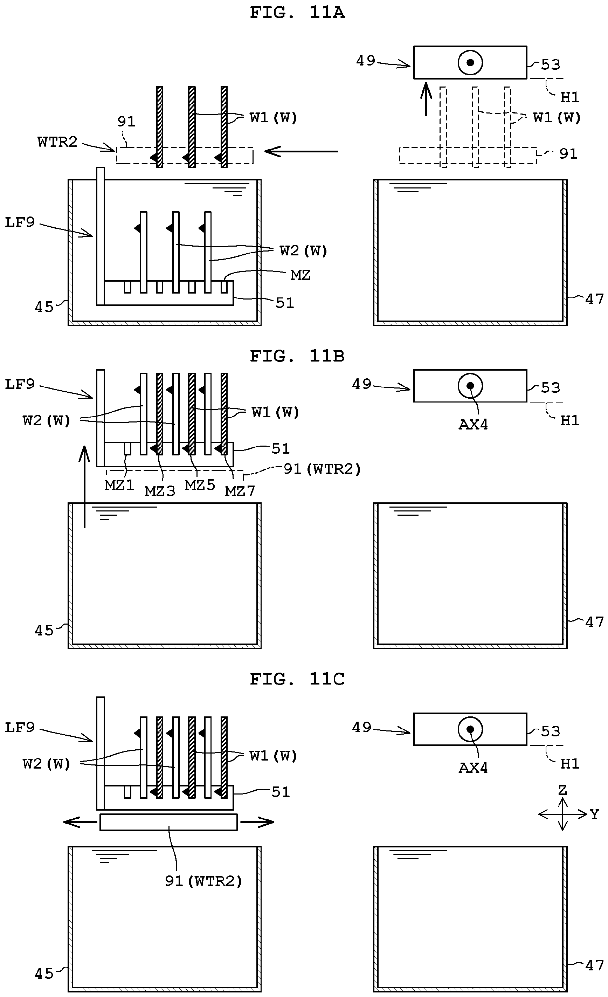

Reference is made to FIG. 11A. Thereafter, the attitude changer 49 raises the reversing chuck 53 to the upper position H1 where the reversing chuck 53 does not interfere with the 25 substrates W1. Thereafter, the batch transport robot WTR2 retracts the 25 substrates W1 subjected to the vertical inversion operation from the delivery position to a position above the standby lifter LF9. At this time, the batch transport robot WTR2 shifts the 25 substrates W1 from the extraction position (original position) of the standby lifter LF9 by one pitch such that the device surface of each substrate W1 faces one substrate W2 of the second substrate group after the vertical inversion of the 50 substrates W1 and W2. In this case, one pitch is each interval (for example, 10 mm) between the 25 substrates W1.

For example, it is assumed that the standby lifter LF9 holds the 25 substrates W1 (first substrate group) in the first, third, fifth,..., 45-th, 47-th, and 49-th holding grooves MZ before the vertical inversion operation is performed. After the vertical inversion operation is performed, the batch transport robot WTR2 adjusts the positions in the width direction Y of the 25 substrates W1 held by the extraction chuck 91 such that the standby lifter LF9 holds the 25 substrates W1 in the third, fifth, seventh,..., 47-th, 49-th, and 51-st holding grooves. The first holding groove MZ and the third holding groove MZ are provided on the proximal end side of the support members 51, and the 49-th holding groove MZ and the 51-st holding groove MZ are provided on the distal end side of the support members 51.

Reference is made to FIG. 11B. After the 25 substrates W1 are moved to a preset position above the standby lifter LF9, the standby lifter LF9 raises the support members 51 holding the 25 substrates W2 (second substrate group). As a result, the standby lifter LF9 holds the 25 substrates W1 from below in addition to the 25 substrates W2. The standby lifter LF9 raises the support members 51 to a position higher than the extraction chuck 91.

In FIG. 11B, for convenience of illustration, the standby lifter LF9 holds three substrates W1 and three substrates W2, and includes first to seventh holding grooves MZ. In FIG. 9B, the standby lifter LF9 holds the three substrates W1 in the first, third, and fifth holding grooves MZ. After the vertical inversion operation is performed, the standby lifter LF9 holds the three substrates W1 in the third, fifth, and seventh holding grooves MZ as illustrated in FIG. 11B. In FIGS. 9B and 11B, the first, third, fifth, and seventh holding grooves MZ are denoted by reference signs MZ1, MZ3, MZ5, and MZ7, respectively.

### [Step S18] Extract Second Substrate Group by Extraction Chuck

Next, the operation on the 25 substrates W2 as the second substrate group will be described. Note that overlapping description with steps S13 to S17 will be omitted as appropriate.

Reference is made to FIG. 11C. The standby lifter LF9 holds the 50 substrates W including the 25 substrates W1 subjected to the vertical inversion operation. The batch transport robot WTR2 moves the extraction chuck 91 to a preset position in the arrangement direction (width direction Y) of the 50 substrates W to extract the 25 substrates W2 (second substrate group or even-numbered substrate group). The extraction chuck 91 is in a closed state.

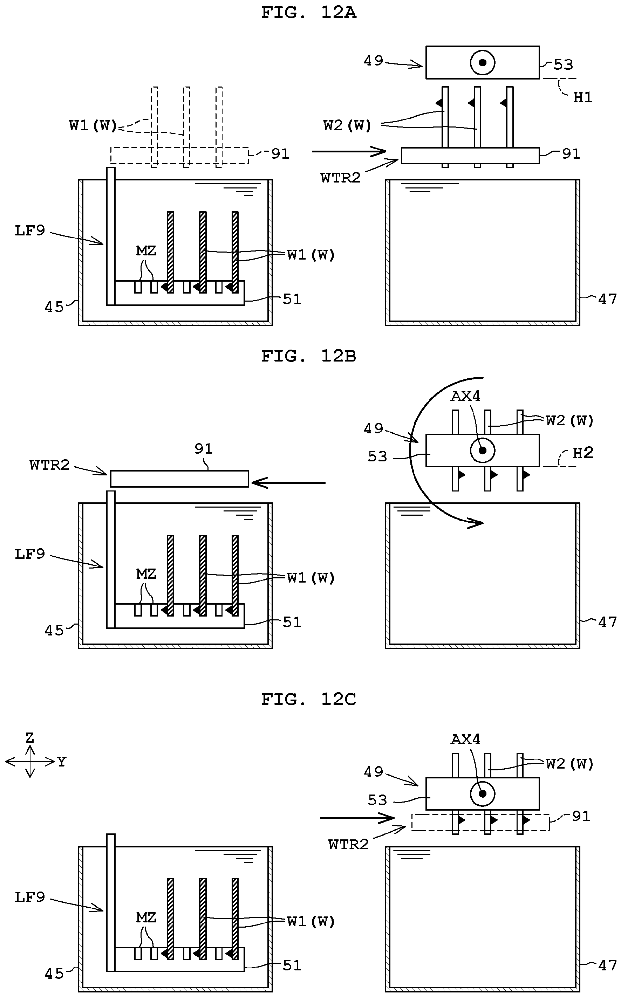

Reference is made to FIG. 12A. Thereafter, the standby lifter LF9 lowers the 50 substrates W. As a result, the 25 substrates W2 are held by the extraction chuck 91, and the 25 substrates W1 are left in the standby lifter LF9. Thereafter, the standby lifter LF9 immerses the 25 substrates W1 in the pure water in the standby tank 45.

### [Step S19] Transport Second Substrate Group to Reversing Chuck

Thereafter, the batch transport robot WTR2 advances the 25 substrates W2 held by the extraction chuck 91 to the delivery position below the reversing chuck 53. Thereafter, the attitude changer 49 lowers the reversing chuck 53 to the delivery height position H2. Thereafter, the attitude changer 49 closes the reversing chuck 53. As a result, the reversing chuck 53 holds the 25 substrates W2.

Reference is made to FIG. 12B. Thereafter, the batch transport robot WTR2 opens the extraction chuck 91. Thereafter, the batch transport robot WTR2 retracts the extraction chuck 91 in the width direction Y to the position above the standby lifter LF9.

### [Step S20] Vertically Invert Second Substrate Group by Reversing Chuck

Thereafter, the attitude changer 49 rotates the 25 substrates W2 subjected to the first batch processing about the horizontal axis AX4. As a result, the 25 substrates W2 in the vertical attitude are vertically inverted.

### [Step S21] Transport Second Substrate Group to Extraction Chuck

Reference is made to FIG. 12C. After the vertical inversion operation on the 25 substrates W2 (second substrate group), the batch transport robot WTR2 advances the extraction chuck 91 to the delivery position below the reversing chuck 53. At this time, the extraction chuck 91 is in an open state.

Thereafter, the batch transport robot WTR2 causes the extraction chuck 91 to hold the 25 substrates W2 from below by closing the extraction chuck 91. Thereafter, the attitude changer 49 opens the reversing chuck 53. As a result, the 25 substrates W2 are held only by the extraction chuck 91.

### [Step S22] Transport Second Substrate Group to Standby Lifter

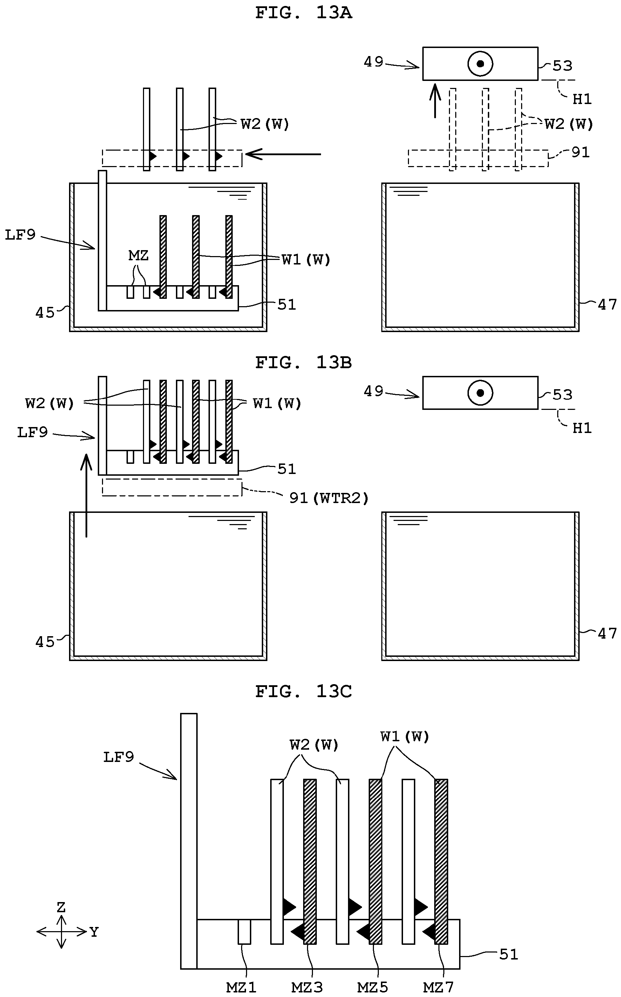

Reference is made to FIG. 13A. Thereafter, the attitude changer 49 raises the reversing chuck 53 to the upper position H1. Thereafter, the batch transport robot WTR2 retracts the 25 substrates W2 subjected to the vertical inversion operation from the delivery position to the position above the standby lifter LF9.

At this time, the batch transport robot WTR2 adjusts the positions of the 25 substrates W2 in the width direction Y (substrate arrangement direction) such that the 25 substrates W2 return to the holding grooves MZ in which the 25 substrates W2 are held before the vertical inversion operation is performed. For example, it is assumed that the standby lifter LF9 holds the 25 substrates W2 (second substrate group) in the second, fourth, sixth,..., 46-th, 48-th, and 50-th holding grooves MZ before the vertical inversion operation is performed. After the vertical inversion operation is performed, the batch transport robot WTR2 adjusts the positions in the width direction Y of the 25 substrates W2 held by the extraction chuck 91 such that the standby lifter LF9 holds the 25 substrates W2 in the second, fourth, sixth,..., 46-th, 48-th, and 50-th holding grooves MZ.

Reference is made to FIG. 13B. After the adjustment of the positions in the width direction Y of the 25 substrates W2, the standby lifter LF9 further holds the 25 substrates W2 by raising the support members 51 holding the 25 substrates W1. Thereafter, the extraction chuck 91 is opened. With such an operation, the vertical inversion operation of the 50 substrates W is performed as illustrated in FIG. 13C. The vertically-inverted 25 substrates W1 and the vertically-inverted 25 substrates W2 are transported to the standby lifter LF9 by the batch transport robot WTR2 such that all the device surfaces of the 25 substrates W1 and all the device surfaces of the 25 substrates W2 face each other. Thereafter, the standby lifter LF9 immerses the 50 substrates W in the pure water in the standby tank 45 in order to prevent drying of the substrates W, for example.

### [Step S23] Transport Processing Substrate Group to Chemical Treatment Tank

The batch transport robot WTR1 transports the vertically-inverted 50 substrates W in the vertical attitude from the standby lifter LF9 to any of the two lifters LF1 and LF3. Specifically, the batch transport robot WTR1 receives the vertically-inverted 50 substrates W from the standby lifter LF9 in the vertical attitude. At this time, the standby lifter LF9 lifts the 50 substrates W from the pure water in the standby tank 45. Thereafter, the batch transport robot WTR1 transports the vertically-inverted 50 substrates W to any of the two lifters LF1 and LF3. For example, the batch transport robot WTR1 transports the 50 substrates W to the lifter LF1 in the vertical attitude. At this time, the lifter LF1 receives the 50 substrates W at the position above the chemical treatment tank BT1.

### [Step S24] Second Batch Processing

The lifter LF1 immerses the 50 substrates W in the phosphoric acid solution that is the chemical liquid in the chemical treatment tank BT1. As a result, the second batch processing (etching treatment) is performed. Similarly to the first batch processing, the second batch processing is also performed until half (for example, two hours) of the normal processing time elapses. After the second batch processing, the lifter LF1 lifts the 50 substrates W from the phosphoric acid solution in the chemical treatment tank BT1.

Thereafter, the batch transport robot WTR1 receives the 50 substrates W in the vertical attitude, for example, from the lifter LF1, and transports the 50 substrates W to the lifter LF2 of the cleaning treatment tank BT2. The lifter LF2 receives the 50 substrates W at the position above the cleaning treatment tank BT2. The lifter LF2 immerses the 50 substrates W in the pure water in the cleaning treatment tank BT2. As a result, a cleaning treatment (batch processing) is performed.

In a case where the batch transport robot WTR1 receives the 50 substrates W in the vertical attitude from the lifter LF3, the batch transport robot WTR1 transports the 50 substrates W to the lifter LF4 of the cleaning treatment tank BT4. In a case where the 50 substrates W are transported to the lifter LF3, the chemical treatment tank BT3 performs the same treatment as the chemical treatment tank BT1. In a case where the 50 substrates W are transported to the lifter LF4, the cleaning treatment tank BT4 performs the same treatment as the cleaning treatment tank BT2.

### [Step S04] Change to Horizontal Attitude

The description returns to the flowchart of FIG. 6. The batch transport robot WTR1 receives the 50 substrates W subjected to the second batch processing (etching treatment and cleaning treatment) from any of the lifters LF2 and LF4. At this time, for example, the lifter LF2 lifts the 50 substrates W from the pure water in the cleaning treatment tank BT2. The batch transport robot WTR1 transports the 50 substrates W subjected to the second batch processing to the second attitude changing mechanism 43. The standby lifter LF9 receives the 50 substrates W from the batch transport robot WTR1 at a position above the standby tank 45, and immerses the 50 substrates W in the pure water in the standby tank 45.

Thereafter, the batch transport robot WTR2 extracts the 25 substrates W1 (first substrate group) from the 50 substrates W held by the standby lifter LF9, and transports the extracted 25 substrates W1 to the reversing chuck 53. This operation is performed as in steps S13 and S14 in FIG. 7. After the 25 substrates W1 are transported to the reversing chuck 53, the attitude changer 49 lowers the reversing chuck 53 holding the 25 substrates W1 to immerse the 25 substrates W1 in the pure water in the attitude changing tank 47.

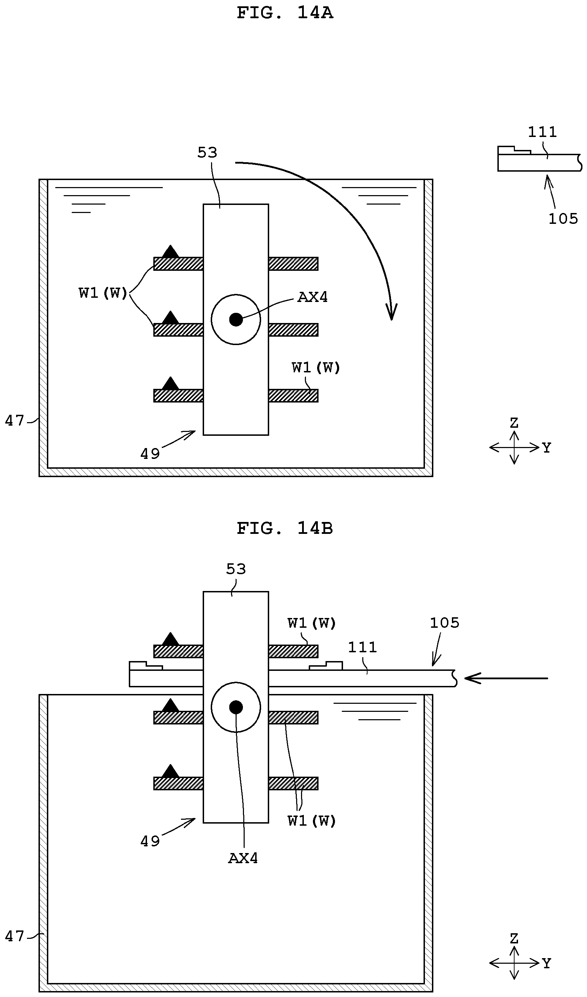

Reference is made to FIG. 14A. Thereafter, the attitude changer 49 changes the 25 substrates W1 subjected to the second batch processing from the vertical attitude to the horizontal attitude by rotating the reversing chuck 53 about the horizontal axis AX4. At this time, the attitude changer 49 rotates the reversing chuck 53 holding the 25 substrates W1 such that the device surface of each substrate W1 faces upward. For example, in FIG. 14A, the reversing chuck 53 is rotated clockwise by 90 degrees about the horizontal axis AX4.

Reference is made to FIG. 14B. In a case where the substrates W1 are transported to the single-wafer processing apparatus 7, the attitude changer 49 raises the reversing chuck 53, so that the substrate W1 at the highest position held in the horizontal attitude by the reversing chuck 53 is lifted from the pure water in the attitude changing tank 47. The substrate transport robot 105 provided in the relay region R3 causes the relay hand 111 to enter the reversing chuck 53, and then takes out the substrate W in the horizontal attitude lifted from the pure water while holding up the substrate W. When the substrate W is taken out from the reversing chuck 53, the reversing chuck 53 is in an open state. The substrate transport robot 105 transports the taken-out substrate W1 to the substrate placement part PS1 (FIG. 1). Similarly, the substrate transport robot 105 transports the remaining substrates W1 one by one in the horizontal attitude from the reversing chuck 53 to the substrate placement part PS1.

After all the substrates W1 (first substrate group) are transported from the reversing chuck 53, the batch transport robot WTR2 receives the 25 substrates W2 left in the standby lifter LF9, and transports the 25 substrates W2 to the reversing chuck 53. This operation is performed as in steps S18 and S19 in FIG. 8. After the 25 substrates W2 are transported to the reversing chuck 53, the attitude changer 49 immerses the 25 substrates W2 in the pure water in the attitude changing tank 47.

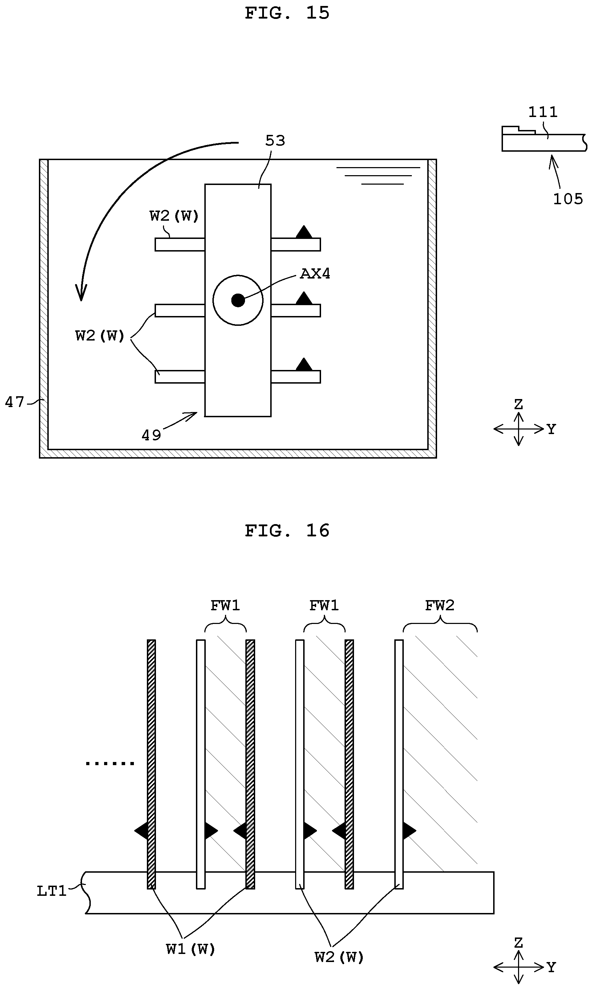

Reference is made to FIG. 15. The attitude changer 49 changes the 25 substrates W2 subjected to the second batch processing from the vertical attitude to the horizontal attitude such that the device surface of each substrate W2 faces upward. For example, in FIG. 15, the reversing chuck 53 is rotated counterclockwise by 90 degrees about the horizontal axis AX4.

Thereafter, the attitude changer 49 lifts the 25 substrates W2 in the horizontal attitude one by one from the pure water in the attitude changing tank 47. Correspondingly, the substrate transport robot 105 transports the lifted substrate W2 from the reversing chuck 53 to the substrate placement part PS1.

### [Step S05] First Single-Wafer Processing

Reference is made to FIG. 1. The center robot CR uses the first hand 151 out of the two hands 151 to receive one wet substrate W placed on the substrate placement part PS1, and transports the single substrate W to any of the five single-wafer processing chambers SW1 of the two towers TW1 and TW3. The holding rotator 141 of each single-wafer processing chamber SW1 holds in the horizontal attitude and rotates the substrate W whose device surface faces upward. Each single-wafer processing chamber SW1 supplies pure water from the nozzle 143 to the device surface (upper surface) of the rotated substrate W, and then supplies IPA from the nozzle 143 to the device surface. As a result, the pure water on the substrate W is replaced with the IPA.

### [Step S06] Second Single-Wafer Processing

The center robot CR uses the first hand 151 to receive the single wet substrate W subjected to the replacement treatment with the IPA from any of the five single-wafer processing chambers SW1, and transports the substrate W to any of the six single-wafer processing chambers SW2. Each single-wafer processing chamber SW2 dries the single substrate W with carbon dioxide (supercritical fluid) in a supercritical state. Pattern collapse of a pattern surface (device surface) of the substrate W is inhibited by the drying treatment using the supercritical fluid.

### [Step S07] Transport Substrates to Carrier

The center robot CR uses the second hand 151 to receive the single substrate W subjected to the drying treatment from any of the six single-wafer processing chambers SW2, and transports the single substrate W to the substrate placement part PS2. The 50 substrates W1 and W2 subjected to the drying treatment are sequentially transported to the substrate placement part PS2.

The indexer robot IR uses the hand 127 to transport the substrates W1 of the first substrate group placed on the substrate placement part PS2 to the first carrier C placed on the placement shelf 125. When the 25 substrates W1 subjected to the drying treatment are transported to the first carrier C, the external transport robot (not illustrated) transports the first carrier C from the placement shelf 125 to a next destination.

The indexer robot IR uses the hand 127 to transport the substrates W2 of the second substrate group placed on the substrate placement part PS2 to the second carrier C placed on the placement shelf 125. When the 25 substrates W2 subjected to the drying treatment are transported to the second carrier C, the external transport robot transports the second carrier C from the placement shelf 125 to the next destination.

According to the present embodiment, the first batch processing and the second batch processing in which the plurality of substrates W are immersed in the chemical liquid in the chemical treatment tank BT1 are performed. Here, the second attitude changing mechanism 43 rotates the plurality of substrates W subjected to the first batch processing about the horizontal axis AX4, thereby vertically inverting the plurality of substrates W in the vertical attitude. That is, the operation of vertically inverting the plurality of substrates W in the vertical attitude is performed between the first batch processing and the second batch processing. This makes it possible to reduce processing variations occurring between the upper half and the lower half of each substrate W.

For example, in a case where the substrates Ware not vertically inverted by the second attitude changing mechanism 43, the following operation is conceivable. That is, the substrates W subjected to the first batch processing are dried, and then the substrates W are returned to the carrier C. The substrates W are vertically inverted by another apparatus of the substrate processing system 1. Thereafter, in the substrate processing system 1, the second batch processing is performed on the vertically-inverted substrates W. In this case, the substrates W are dried in order to be vertically inverted by the other apparatus. Thus, there is a possibility that pattern collapse occurs in the substrates W due to drying. There is also a possibility that particles adhere to the substrates W and that an oxide film adheres to the substrates W by being transported to the other apparatus or the like. In a case where the oxide film adheres, it may become necessary to remove the oxide film. However, according to the present embodiment, since the vertical inversion operation of the substrates W is performed in the substrate processing system 1, these possibilities can be avoided.

The operation of vertically inverting the plurality of substrates W in the vertical attitude is performed by rotating the reversing chuck 53 holding the plurality of substrates W about the horizontal axis AX4.

In the reversing chuck 53, the first support portion SU1 and the second support portion SU2 of each pair of holding grooves 57 and 58 can stop the movement of the single substrate W in both the substrate in/out directions DR1 as illustrated in FIG. 5B. This makes it possible to easily perform the operation of vertically inverting the plurality of substrates W in the vertical attitude.

The substrate processing system 1 includes the single-wafer processing apparatus 7 and the relay apparatus 5 in addition to the batch processing apparatus 3. The plurality of substrates W subjected to the second batch processing are sent to the single-wafer processing apparatus 7 through the relay apparatus 5. Here, in addition to the operation of vertically inverting the plurality of substrates W in the vertical attitude, the second attitude changing mechanism 43 performs the operation of changing the plurality of substrates W from the vertical attitude to the horizontal attitude. In other words, the second attitude changing mechanism 43 performs the vertical inversion operation in addition to the changing operation to the horizontal attitude. Therefore, it is not necessary to separately provide a mechanism for performing the change to the horizontal attitude and a mechanism for performing the vertical inversion operation, so that the substrate processing system 1 can be configured compactly.

The substrate processing system 1 can reduce processing variations occurring between the upper half and the lower half of each substrate W of the processing substrate group by vertically inverting the processing substrate group (50 substrates W1 and W2) in which the 25 substrates W1 and the 25 substrates W2 are alternately disposed.

The processing substrate group (50 substrates W) is formed such that the 25 substrates W1 and the 25 substrates W2 are alternately disposed and all the device surfaces of the 25 substrates W1 and all the device surfaces of the 25 substrates W2 face each other. Reference is made to FIG. 16. It is assumed that two device surfaces of two substrates W at opposite ends do not face two device surfaces of other two substrates W in the direction in which the processing substrate group is arranged after the processing substrate group (50 substrates W) is vertically inverted. In this case, when the batch processing is performed, for example, a different amount of chemical liquid flows between the substrate W whose device surface faces no device surface and the two substrates W whose device surfaces face each other.

For example, as indicated by reference sign FW1 in FIG. 16, a certain space is formed between the two substrates W1 and W2 whose device surfaces face each other. On the other hand, as indicated by reference sign FW2, the certain space indicated by reference sign FW1 is not formed at the substrate W2 whose device surface faces no device surface. Therefore, for example, the amounts of chemical liquid flowing into the spaces indicated by reference signs FW1 and FW2 are different. Thus, there is a possibility of causing processing variations. Such processing variations can be prevented by making all the device surfaces of the 25 substrates W1 and all the device surfaces of the 25 substrates W2 face each other after the processing substrate group is vertically inverted.

### [Second Embodiment]

Next, a second embodiment of the present invention will be described with reference to the drawings. Note that overlapping description with the first embodiment will be omitted.

In the first embodiment, for example, the attitude changer 49 vertically inverts the 25 substrates W1 in one time by rotating the reversing chuck 53 by 180 degrees about the horizontal axis AX4. In this regard, in the second embodiment, the attitude changer 49 changes the 25 substrates W1 from the vertical attitude to the horizontal attitude, and further changes the 25 substrates W1 from the horizontal attitude to the vertical attitude. As a result, the 25 substrates W1 are vertically inverted. Here, a rearrangement operation of the 25 substrates W1 in the reversing chuck 53 is performed between the two times of attitude change.

In order to perform the rearrangement operation, the reversing chuck 53 includes a plurality of pairs (for example, 27 pairs) of the holding grooves 57 and 58 more than the plurality of (for example, 25) substrates W1 held by the reversing chuck 53.

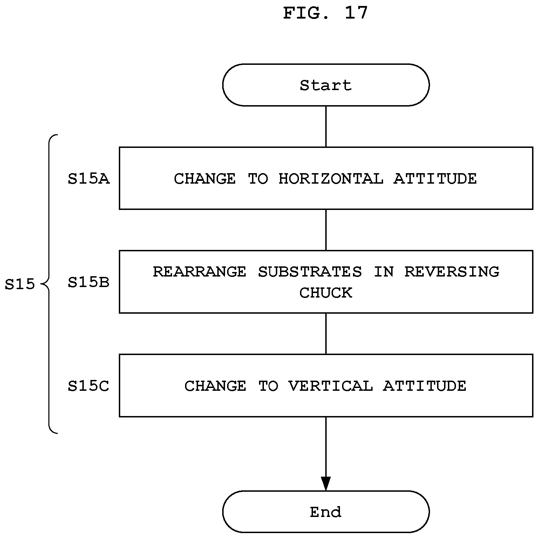

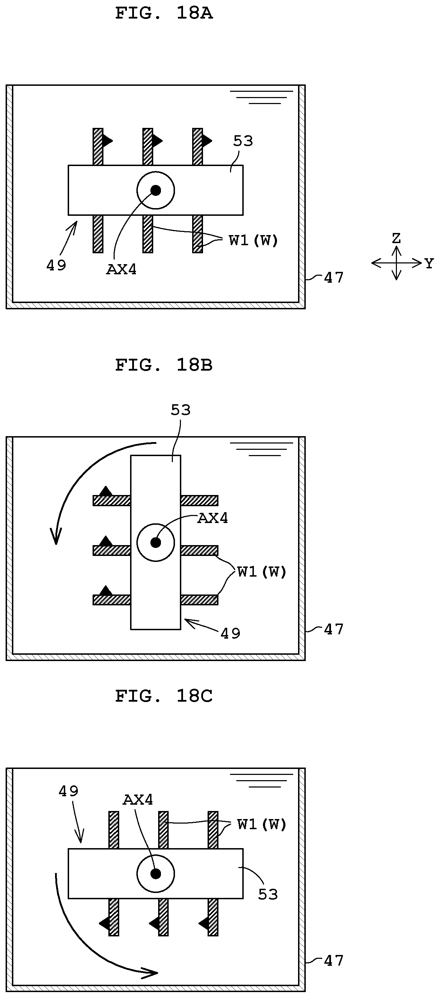

FIG. 17 is a flowchart illustrating a detailed vertical inversion operation of the 25 substrates W1 (first substrate group) by the reversing chuck 53 according to the second embodiment. FIG. 18A is a longitudinal sectional view illustrating a state before the 25 substrates W1 are vertically inverted. FIG. 18B is a longitudinal sectional view illustrating a state in which the 25 substrates W1 are changed from the vertical attitude to the horizontal attitude. FIG. 18C is a longitudinal sectional view illustrating a state (a state after the vertical inversion) in which the 25 substrates W1 are changed from the horizontal attitude to the vertical attitude.

The vertical inversion operation on the 25 substrates W1 and the vertical inversion operation on the 25 substrates W2 are performed as illustrated in FIGS. 7 and 8. The vertical inversion operation on the 25 substrates W1 is performed substantially in the same manner as the vertical inversion operation on the 25 substrates W2. Therefore, the vertical inversion operation on the 25 substrates W1 will be described as a representative example. As illustrated in FIG. 17, step S15 illustrated in FIG. 7 includes three steps S15A, S15B, and S15C.

The batch transport robot WTR2 transports the 25 substrates W1 extracted by the extraction chuck 91 to the attitude changer 49 in the vertical attitude. The attitude changer 49 receives the 25 substrates W1 in the vertical attitude from the batch transport robot WTR2 using the reversing chuck 53. When the reversing chuck 53 is closed, the reversing chuck 53 holds the 25 substrates W1.

### [Step S15A] Change to Horizontal Attitude

Thereafter, the attitude changer 49 lowers the reversing chuck 53 to immerse the 25 substrates W1 in the pure water in the attitude changing tank 47. Thereafter, the attitude changer 49 changes the 25 substrates W1 subjected to the first batch processing from the vertical attitude to the horizontal attitude by rotating the reversing chuck 53 about the horizontal axis AX4 while holding the 25 substrates W1 by the reversing chuck 53. At this time, the 25 substrates W1 are changed to the horizontal attitude such that the device surface of each substrate W1 faces upward. As illustrated in FIGS. 18A and 18B, the reversing chuck 53 is rotated counterclockwise by 90 degrees, but may be rotated clockwise by 270 degrees.

### [Step S15B] Rearrange Substrates in Reversing Chuck

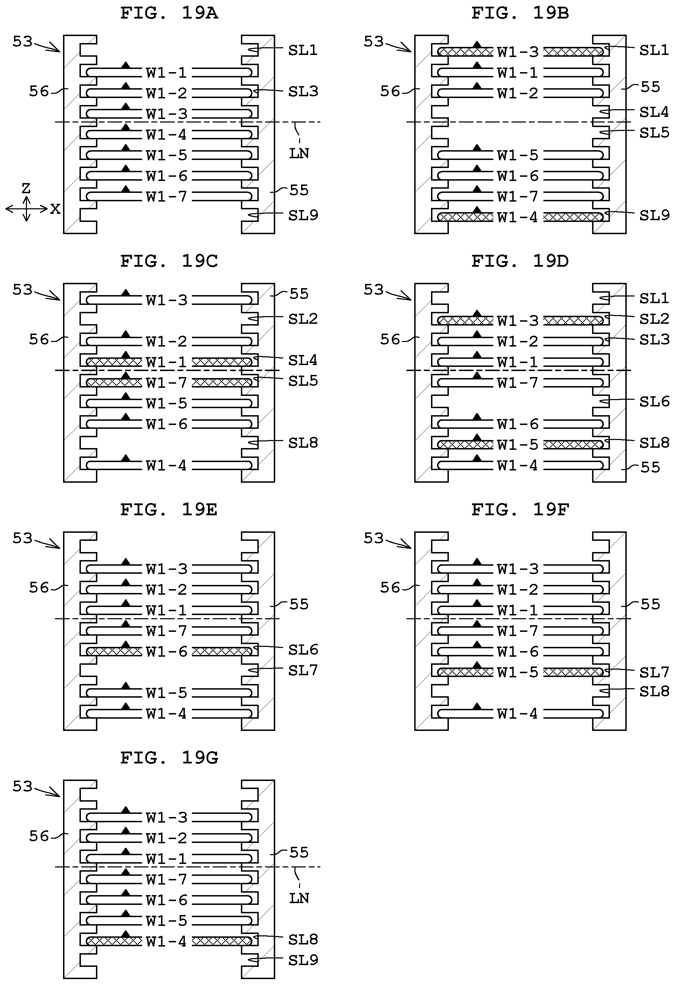

FIGS. 19A to 19G are front views for explaining the rearrangement operation of the substrates W in the reversing chuck 53. In FIGS. 19A to 19G, for convenience of illustration, seven substrates W1 are accommodated in the reversing chuck 53. In order to distinguish the seven substrates W1, the seven substrates W1 are denoted by reference signs W1-1, W1-2, W1-3, W1-4, W1-5, W1-6, and W1-7. In FIGS. 19A to 19G, the reversing chuck 53 includes, for example, nine pairs of holding grooves 57 and 58 more than the seven substrates W1. In the reversing chuck 53, in order to distinguish the nine pairs of holding grooves 57 and 58, the positions of the nine pairs of holding grooves 57 and 58 are denoted by reference signs SL1 to SL9.

First, as illustrated in FIGS. 5A and 5B, the attitude changer 49 opens the reversing chuck 53 to take the substrates W1 in and out of the reversing chuck 53. Thereafter, the substrate transport robot 105 in the relay region R3 performs the rearrangement operation of rearranging the 25 substrates W1 changed to the horizontal attitude by the attitude changer 49 in the reversing chuck 53 so as to exchange the positions of the outer substrate W1 and the inner substrate W1 in the direction (vertical direction Z) in which the 25 substrates W1 are arranged.

This operation will be specifically described. FIG. 19A illustrates a state before the rearrangement operation of the substrates W1. The rearrangement operation is performed in two regions as indicated by one-dot chain line LN in FIG. 19A. One-dot chain line LN is set in advance at substantially the center of the 25 substrates W1 in the direction in which the 25 substrates W1 are arranged. Reference is made to FIG. 19B. The substrate transport robot 105 moves the third substrate W1-3 from the position SL4 to the position SL1 using the relay hand 111. The substrate transport robot 105 also moves the fourth substrate W1-4 from the position SL5 to the position SL9 using the relay hand 111.

The rearrangement operation is performed by combining the raising/lowering operation of the reversing chuck 53 by the attitude changer 49 and the advancing/retracting operation of the relay hand 111 by the substrate transport robot 105. When the reversing chuck 53 is raised and lowered, the reversing chuck 53 may be in a closed state. The substrate transport robot 105 may include a raising/lowering part (having an electric motor) capable of raising and lowering the relay hand 111 and the advancing/retracting part 113.

Reference is made to FIG. 19C. Thereafter, the substrate transport robot 105 moves the first substrate W1-1 from the position SL2 to the position SL4. The substrate transport robot 105 also moves the seventh substrate W1-7 from the position SL8 to the position SL5.

Reference is made to FIG. 19D. Thereafter, the substrate transport robot 105 moves the third substrate W1-3 from the position SL1 to the position SL2. As a result, the rearrangement of the three substrates W1 above one-dot chain line LN is completed. In the case of the arrangement of the seven substrates W1 in FIG. 19A, the second substrate W1-2 at the position SL3 is not moved. In FIG. 19D, the substrate transport robot 105 moves the fifth substrate W1-5 from the position SL6 to the position SL8.

Reference is made to FIG. 19E. Thereafter, the substrate transport robot 105 moves the sixth substrate W1-6 from the position SL7 to the position SL6. Reference is made to FIG. 19F. Thereafter, the fifth substrate W1-5 is moved from the position SL8 to the position SL7. Reference is made to FIG. 19G. Thereafter, the fourth substrate W1-4 is moved from the position SL9 to the position SL8. As a result, the rearrangement operation of the four substrates W1 below one-dot chain line LN is completed, and the rearrangement operation of the seven substrates W1 is completed. The positions of the outer substrate W1 and the inner substrate W1 illustrated in FIG. 19G are exchanged with respect to the substrates W1 illustrated in FIG. 19A.

After the three substrates W1-1, W1-2, and W1-3 are rearranged, the four substrates W1-4, W1-5, W1-6, and W1-7 may be rearranged. After the four substrates W1-4, W1-5, W1-6, and W1-7 are rearranged, the three substrates W1-1, W1-2, and W1-3 may be rearranged.

### [Step S15C] Change to Vertical Attitude

Thereafter, the attitude changer 49 closes the reversing chuck 53. Thereafter, the attitude changer 49 further rotates the reversing chuck 53 about the horizontal axis AX4 while holding the 25 substrates W1 by the reversing chuck 53. For example, in FIG. 18C, the attitude changer 49 rotates the reversing chuck 53 counterclockwise by 90 degrees, but may rotate the reversing chuck 53 clockwise by 270 degrees. As a result, the attitude changer 49 changes the 25 substrates W1 subjected to the rearrangement operation from the horizontal attitude to the vertical attitude so as to vertically invert the 25 substrates W1 in the vertical attitude obtained when the first batch processing is performed.

That is, as illustrated in FIG. 18C, the vertical inversion operation is performed on the 25 substrates W1 illustrated in FIG. 18A. The rearrangement operation similar to that on the 25 substrates W1 of the first substrate group is performed on the 25 substrates W2 of the second substrate group.

Thereafter, in the step of performing the change to the horizontal attitude (step S04) illustrated in FIG. 6, the arrangement of the 25 substrates W1 and the 25 substrates W2 remains in the state where the rearrangement operation has been performed. Therefore, for example, after the 25 substrates W1 are changed to the horizontal attitude by the attitude changer 49, the state illustrated in FIG. 19G is obtained. The substrate transport robot 105 of the relay apparatus 5 uses the relay hand 111 to transport the substrates W1 one by one from the reversing chuck 53 to the substrate placement part PS1 in the order of the substrates W1-1, W1-2, W1-3, W1-4, W1-5, W1-6, and W1-7. The same applies to the case of the 25 substrates W2 subjected to the rearrangement operation.

According to the present embodiment, the rearrangement operation is performed in addition to the operation of vertically inverting the 25 substrates W in the vertical attitude. The rearrangement operation is an operation of rearranging the 25 substrates changed to the horizontal attitude in the reversing chuck 53 so as to exchange the positions of the outer substrate W and the inner substrate W in the direction in which the 25 substrates W are arranged. This makes it possible to reduce processing variations occurring between the outer substrate W and the inner substrate W in the direction in which the 25 substrates W are arranged.

### [Third Embodiment]

Next, a third embodiment of the present invention will be described with reference to the drawings. Note that overlapping description with the first and second embodiments will be omitted.

In the first and second embodiments, the 50 substrates W subjected to the second batch processing (chemical treatment and pure water cleaning treatment) are subjected to the drying treatment in the single-wafer processing apparatus 7. In the third embodiment, the 50 substrates W subjected to the second batch processing may be subjected to the drying treatment in the batch processing apparatus 3.

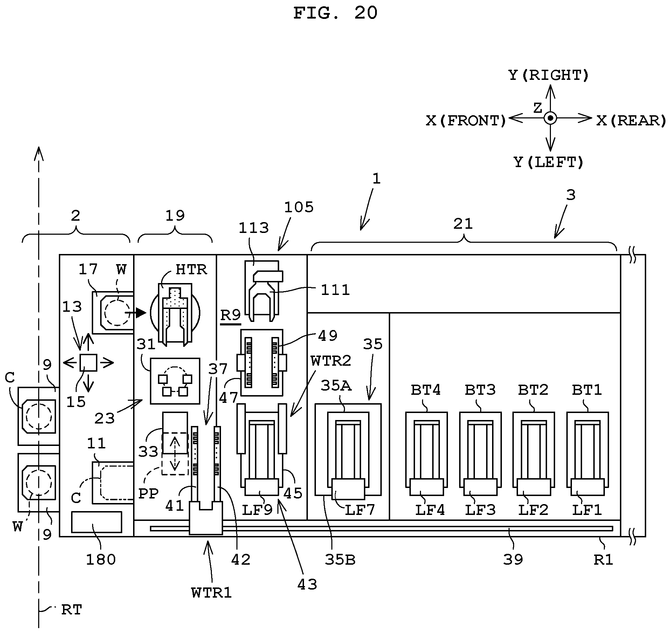

As illustrated in FIG. 1, the substrate processing system 1 of the present embodiment may include the stocker apparatus 2, the batch processing apparatus 3, the relay apparatus 5, and the single-wafer processing apparatus 7. As illustrated in FIG. 20, the substrate processing system 1 of the present embodiment may include the stocker apparatus 2 and the batch processing apparatus 3 without including the single-wafer processing apparatus 7. In this case, the batch processing apparatus 3 may include the second attitude changing mechanism 43 and the substrate transport robot 105 in a region R9 between the transfer block 19 and the processing block 21.

In FIG. 20, the standby tank 45, the attitude changing tank 47, and the substrate transport robot 105 are disposed to the right side in this order. The substrate transport robot 105 does not have to include the rotator 115 and the horizontal mover 117 illustrated in FIG. 1.

As illustrated in FIGS. 1 and 20, the batch processing apparatus 3 includes the batch dryer 35 that collectively dries the plurality of (for example, 50) substrates W. The batch transport robot WTR1 transports the 50 substrates W among the first attitude changing mechanism 23, the four lifters LF1 to LF4, the second attitude changing mechanism 43, and the lifter LF7 of the batch dryer 35 while holding the 50 substrates W in the vertical attitude.

The batch dryer 35 will be described in detail. The batch dryer 35 includes a treatment tank 35A, a chamber 35B that accommodates the treatment tank 35A, and the lifter LF7. The treatment tank 35A stores pure water such as DIW ejected from an ejection pipe (not illustrated). The lifter LF7 ascends and descends. The lifter LF7 includes an electric motor or an air cylinder for raising and lowering the plurality of substrates W. The lifter LF7 includes a plurality of (for example, 50 or 51 or more) holding grooves disposed in the width direction Y, and holds the plurality of (for example, 50) substrates W in the vertical attitude. A movable lid is provided on an upper portion of the chamber 35B. In the chamber 35B, a solvent nozzle and a water repellent nozzle are provided. The inside of the chamber 35B is configured to be decompressed by a vacuum pump.

Here, an operation of the batch dryer 35 will be described. The plurality of substrates W subjected to the pure water cleaning treatment in one of the cleaning treatment tanks BT2 and BT4 are transported to a position above the lifter LF7 of the batch dryer 35 by the batch transport robot WTR1. The lifter LF7 ascends to receive the plurality of substrates W from the batch transport robot, and descends to immerse the plurality of substrates W in the pure water in the treatment tank 35A. Thereafter, the movable lid is closed, and the inside of the chamber 35B is decompressed by the vacuum pump. Thereafter, for example, isopropyl alcohol (IPA) vapor is ejected from the solvent nozzle as a solvent. As a result, the inside of the chamber 35B has an IPA vapor atmosphere.

Thereafter, in the chamber 35B, the lifter LF7 lifts the plurality of substrates W from the pure water in the treatment tank 35A. As a result, the pure water adhering to each substrate W is replaced with the IPA. Thereafter, water repellent vapor is ejected from the water repellent nozzle. As a result, the IPA adhering to each substrate W is replaced with the water repellent. The water repellent modifies the surface of the substrate W to have water repellency. Thereafter, IPA vapor is ejected from the solvent nozzle again. As a result, the water repellent adhering to each substrate is replaced with the IPA. Thereafter, the ejection of the IPA vapor from the solvent nozzle is stopped. As a result, the IPA adhering to each substrate W volatilizes in the decompressed chamber 35B, and the substrate W is more dried. After the drying treatment, the chamber 35B is returned to the atmospheric pressure.

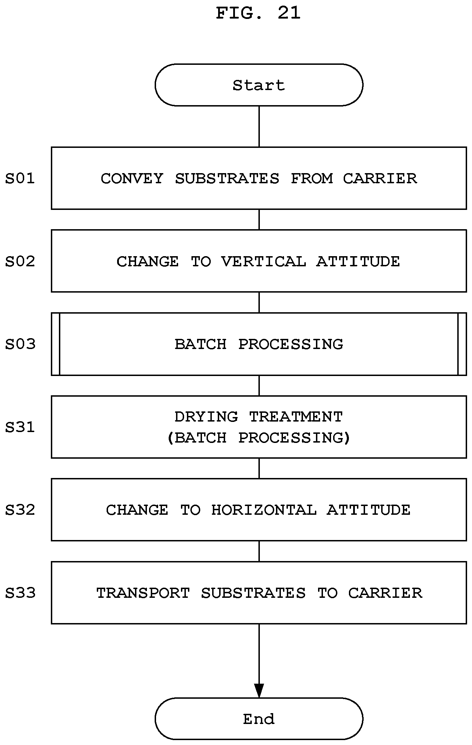

Next, an operation of the substrate processing system 1 of the present embodiment will be described with reference to a flowchart of FIG. 21. Since steps S01 to S03 illustrated in FIG. 21 are substantially the same as the description of steps S01 to S03 illustrated in FIG. 6, the description thereof will be omitted. In step S01, the two carriers C (empty carriers) are placed on the two storage shelves 11.

### [Step S31] Drying Treatment (Batch Processing)

The batch transport robot WTR1 receives the 50 substrates W subjected to the second batch processing (chemical treatment and cleaning treatment) from any of the lifters LF2 and LF4. Thereafter, the batch transport robot WTR1 transports the 50 substrates W subjected to the second batch processing to the batch dryer 35. The batch dryer 35 collectively dries the 50 substrates W.

### [Step S32] Change to Horizontal Attitude

After the drying treatment by the batch dryer 35, the upper portion of the chamber 35B is opened by the movable lid. Thereafter, the lifter LF7 raises the 50 substrates W subjected to the drying treatment to a position above the chamber 35B. The batch transport robot WTR1 receives the 50 substrates W from the lifter LF7 and transports the 50 substrates W to the substrate delivery position PP. The pusher mechanism 33 of the first attitude changing mechanism 23 uses the pusher 33A to receive the 50 substrates W subjected to the drying treatment from the batch transport robot WTR1.

For example, the attitude changer 31 of the first attitude changing mechanism 23 takes out the 25 substrates W1 of the first substrate group from the 50 substrates W held by the pusher 33A. As illustrated in FIG. 13C, the 25 substrates W1 face leftward. Therefore, the attitude changer 31 changes the 25 substrates W1 from the vertical attitude to the horizontal attitude without rotating the 25 substrates W1 by 180 degrees about the vertical axis AX3. As a result, the device surfaces of the 25 substrates W1 changed to the horizontal attitude face upward. The substrate handling mechanism HTR receives the 25 substrates W1 from the attitude changer 31.

Thereafter, the attitude changer 31 receives the 25 substrates W2 of the second substrate group held by the pusher 33A from the pusher 33A. As illustrated in FIG. 13C, the 25 substrates W2 face rightward. Therefore, the attitude changer 31 turns the respective device surfaces of the 25 substrates W2 leftward by rotating the 25 substrates W2 by 180 degrees about the vertical axis AX3. Thereafter, the attitude changer 31 changes the 25 substrates W2 from the vertical attitude to the horizontal attitude.

### [Step S33] Transport Substrates to Carrier

The carrier transport robot 13 transports the first carrier C (empty carrier) from the storage shelf 11 to the placement shelf 17. The substrate handling mechanism HTR transports the received 25 substrates W1 to the first carrier on the placement shelf 17. Thereafter, the carrier transport robot 13 transports the first carrier C accommodating the 25 substrates W1 subjected to the drying treatment to the load port 9.

After the first carrier C accommodating the 25 substrates W1 subjected to the drying treatment is transported from the placement shelf 17, the carrier transport robot 13 transports the second carrier C (empty carrier) from the storage shelf 11 to the placement shelf 17. The substrate handling mechanism HTR transports the 25 substrates W2 changed to the horizontal attitude from the attitude changer 31 to the second carrier C on the placement shelf 17. Thereafter, the carrier transport robot 13 transports the second carrier C accommodating the 25 substrates W2 subjected to the drying treatment to the load port 9.

Thereafter, the external transport mechanism sequentially transports the two carriers C from the load ports 9 to the next destination.

According to the present embodiment, the substrate processing system 1 can collectively dry the 50 substrates subjected to the second batch processing using the batch dryer 35 without sending the 50 substrates W subjected to the second batch processing to the single-wafer processing apparatus 7.

The drying treatment of the batch dryer 35 is performed by supplying the IPA vapor and the water repellent vapor into the chamber 35B, but may be performed by supplying the supercritical fluid into the chamber.

The present invention is not limited to the above embodiments, and can be modified as follows.
(1) In the first and second embodiments described above, the batch dryer 35 is provided. In a case where the batch dryer 35 is not used, the batch dryer 35 does not have to be provided.
(2) In each of the above-described embodiments and Modification (1), the center robot CR transports the substrate W to the indexer robot IR through the substrate placement part PS2. In this regard, the center robot CR may directly transport the substrate W to the indexer robot IR without passing through the substrate placement part PS2. The center robot CR may directly receive the substrate W from the substrate transport robot 105 without passing through the substrate placement part PS1.
(3) In each of the above-described embodiments and modifications, the single-wafer processing apparatus 7 includes the indexer robot IR and the center robot CR as the second horizontal substrate transport robot. The indexer robot IR and the center robot CR jointly transport one substrate W among the substrate placement part PS1 of the relay apparatus 5, the 11 single-wafer processing chambers SW1 and SW2, and the carrier C placed on each placement shelf 125. In this regard, one second horizontal substrate transport robot may transport one substrate W among the substrate placement part PS1 of the relay apparatus 5, the 11 single-wafer processing chambers SW1 and SW2, and the carrier C placed on each placement shelf 125.
   In addition, a plurality of (not limited to two) second horizontal substrate transport robots may jointly transport one substrate W among the substrate placement part PS1 of the relay apparatus 5, the 11 single-wafer processing chambers SW1 and SW2, and the carrier C placed on each placement shelf 125.
(4) In each of the above-described embodiments and modifications, the four batch processing tanks BT1 to BT4 include the two chemical treatment tanks BT1 and BT3 and the two cleaning treatment tanks BT2 and BT4. In this regard, each of the four batch processing tanks BT1 to BT4 may be a treatment tank that sequentially performs a chemical treatment and a cleaning treatment.
(5) In each of the above-described embodiments and modifications, the four lifters LF1 to LF4 are provided in the four batch processing tanks BT1 to BT4, respectively, as illustrated in FIG. 1. In this regard, for example, the lifter LF1 may be used for the two batch processing tanks BT1 and BT2, and the lifter LF3 may be used for the two batch processing tanks BT3 and BT4. In this case, the two lifters LF2 and LF4 are not provided. The lifter LF1 may include a front-rear direction mover including, for example, an electric motor so as to be movable in the front-rear direction X between the two batch processing tanks BT1 and BT2. Similarly to the lifter LF1, the lifter LF3 is also configured to be movable in the front-rear direction X between the two batch processing tanks BT3 and BT4.
(6) In each of the above-described embodiments and modifications, the single-wafer processing chamber SW2 performs the drying treatment of the substrate W using the supercritical fluid. In this regard, the single-wafer processing chamber SW2 may include the holding rotator 141 and the nozzle 143, similarly to the single-wafer processing chamber SW1. In this case, each of the 11 single-wafer processing chambers SW1 and SW2 supplies, for example, pure water and IPA to the substrate W in this order, and then performs the drying treatment (spin drying) of the substrate W.
(7) In each of the above-described embodiments and modifications, each of the chemical treatment tanks BT1 and BT3 collectively performs the chemical treatment of the 50 substrates W taken out from the two carriers C. In this regard, each of the chemical treatment tanks BT1 and BT3 may collectively perform the chemical treatment of the plurality of (for example, 25) substrates W taken out from one carrier C and arranged at the full pitch (for example, at the interval of 10 mm).
(8) In each of the above-described embodiments and modifications, each of the chemical treatment tanks BT1 and BT3 collectively performs the chemical treatment of the 50 substrates (processing substrate group) in which the 25 substrates W1 and the 25 substrates W2 are alternately disposed. Here, the device surfaces of the 25 substrates W1 face the direction opposite to the direction of the device surfaces of the 25 substrates W2. In this regard, the device surfaces of the 25 substrates W1 may face the same direction as the direction of the device surfaces of the 25 substrates W2.
(9) In each of the above-described embodiments and modifications, the attitude changer 49 performs the vertical inversion operation and the changing operation to the horizontal attitude of the 50 substrates W by 25 substrates each. In this regard, the attitude changer 49 may collectively perform the vertical inversion operation and the changing operation to the horizontal attitude of the 50 substrates W.

## Claims

1. A substrate processing system for processing a substrate, the substrate processing system comprising a batch processing apparatus configured to collectively process a plurality of substrates,
the batch processing apparatus including:
a first carrier placement shelf on which a carrier accommodating the plurality of substrates in a horizontal attitude is placed;
a first attitude changing mechanism configured to change the plurality of substrates between the horizontal attitude and a vertical attitude;
a substrate handling mechanism configured to transport the plurality of substrates between the carrier placed on the first carrier placement shelf and the first attitude changing mechanism;
a processing tank storing a chemical liquid;
a lifter configured to be able to immerse the plurality of substrates in the chemical liquid in the processing tank while holding the plurality of substrates in the vertical attitude;
a second attitude changing mechanism configured to rotate the plurality of substrates about a horizontal axis orthogonal to a central axis passing through a center of each substrate;
a first batch transport robot configured to transport the plurality of substrates among the first attitude changing mechanism, the lifter, and the second attitude changing mechanism while holding the plurality of substrates in the vertical attitude; and
a controller,
the controller
controlling the substrate handling mechanism to transport the plurality of substrates in the horizontal attitude received from the carrier placed on the first carrier placement shelf, to the first attitude changing mechanism,
controlling the first attitude changing mechanism to change the plurality of substrates from the horizontal attitude to the vertical attitude,
controlling the first batch transport robot to transport the plurality of substrates changed to the vertical attitude to the lifter,
controlling the lifter to perform first batch processing to immerse the plurality of substrates in the vertical attitude in the chemical liquid in the processing tank,
controlling the first batch transport robot to transport the plurality of substrates subjected to the first batch processing to the second attitude changing mechanism,
controlling the second attitude changing mechanism to rotate the plurality of substrates subjected to the first batch processing about the horizontal axis, to vertically invert the plurality of substrates in the vertical attitude,
controlling the first batch transport robot to transport the plurality of vertically-inverted substrates in the vertical attitude to the lifter, and
controlling the lifter to perform second batch processing to immerse the plurality of vertically-inverted substrates in the vertical attitude in the chemical liquid in the processing tank.

2. The substrate processing system according to claim 1, wherein the second attitude changing mechanism includes a reversing chuck configured to hold the plurality of substrates, and rotates the reversing chuck about the horizontal axis.

3. The substrate processing system according to claim 2, wherein
the reversing chuck includes two chuck members including a plurality of pairs of holding grooves,
the two chuck members are openable and closable along the horizontal axis, and
each of the plurality of pairs of holding grooves includes a first support portion configured to stop movement of one of the substrates to be accommodated in a predetermined direction out of substrate in/out directions orthogonal to a direction in which the two chuck members are opened and closed, the substrate in/out directions being along a device surface of the one substrate to be accommodated, and a second support portion configured to stop movement of the one substrate to be accommodated in a direction opposite to the predetermined direction.

4. The substrate processing system according to claim 2, further comprising
a first horizontal substrate transport robot including a first hand holding one of the substrates in the horizontal attitude and configured to transport the one substrate,
the controller
controlling the second attitude changing mechanism to rotate the reversing chuck about the horizontal axis while holding the plurality of substrates by the reversing chuck, to change the plurality of substrates subjected to the first batch processing from the vertical attitude to the horizontal attitude,
controlling the first horizontal substrate transport robot to perform a rearrangement operation of rearranging the plurality of substrates changed to the horizontal attitude in the reversing chuck so as to exchange positions of an outer substrate and an inner substrate in a direction in which the plurality of substrates are arranged, and
controlling the second attitude changing mechanism to further rotate the reversing chuck about the horizontal axis while holding the plurality of substrates by the reversing chuck, to change the plurality of substrates subjected to the rearrangement operation from the horizontal attitude to the vertical attitude so as to vertically invert the plurality of substrates in the vertical attitude obtained when the first batch processing is performed.

5. The substrate processing system according to claim 1, comprising:
a single-wafer processing apparatus configured to process the plurality of substrates one by one; and a relay apparatus configured to transport the plurality of substrates from the batch processing apparatus to the single-wafer processing apparatus, in addition to the batch processing apparatus,
the relay apparatus including a first horizontal substrate transport robot including a first hand holding one of the substrates in the horizontal attitude and configured to transport the one substrate,
the single-wafer processing apparatus including:
a single-wafer processing chamber configured to perform single-wafer processing on the one substrate in the horizontal attitude;
a second carrier placement shelf on which the carrier is placed; and
a second horizontal substrate transport robot including a second hand holding the one substrate in the horizontal attitude and configured to transport the one substrate among the relay apparatus, the single-wafer processing chamber, and the carrier placed on the second carrier placement shelf,
the controller
controlling the first batch transport robot to transport the plurality of substrates subjected to the second batch processing to the second attitude changing mechanism,
controlling the second attitude changing mechanism to change the plurality of substrates subjected to the second batch processing from the vertical attitude to the horizontal attitude,
controlling the first horizontal substrate transport robot to transport the one substrate changed to the horizontal attitude from the second attitude changing mechanism to the single-wafer processing apparatus,
controlling the second horizontal substrate transport robot to transport the one substrate transported by the first horizontal substrate transport robot to the single-wafer processing chamber,
controlling the single-wafer processing chamber to perform the single-wafer processing on the one substrate, and
controlling the second horizontal substrate transport robot to transport the one substrate subjected to the single-wafer processing from the single-wafer processing chamber to the carrier placed on the second carrier placement shelf.

6. The substrate processing system according to claim 1, wherein
the controller
controls the substrate handling mechanism to transport the plurality of substrates in the horizontal attitude received from a first carrier placed on the first carrier placement shelf to the first attitude changing mechanism, and to transport a plurality of second substrates in a horizontal attitude received from a second carrier placed on the first carrier placement shelf to the first attitude changing mechanism,
controls the first attitude changing mechanism to form a processing substrate group in which the plurality of substrates and the plurality of second substrates are alternately disposed, and to change the processing substrate group from the horizontal attitude to the vertical attitude,
controls the first batch transport robot to transport the processing substrate group in the vertical attitude to the lifter,
controls the lifter to perform the first batch processing to immerse the processing substrate group in the chemical liquid in the processing tank,
controls the first batch transport robot to transport the processing substrate group subjected to the first batch processing to the second attitude changing mechanism,
controls the second attitude changing mechanism to rotate the plurality of substrates in the processing substrate group subjected to the first batch processing about the horizontal axis, and to rotate the plurality of second substrates in the processing substrate group subjected to the first batch processing about the horizontal axis, to vertically invert the plurality of substrates and the plurality of second substrates in the vertical attitude,
controls the first batch transport robot to transport the vertically-inverted processing substrate group in the vertical attitude to the lifter, and
controls the lifter to perform the second batch processing to immerse the vertically-inverted processing substrate group in the vertical attitude in the chemical liquid in the processing tank.

7. The substrate processing system according to claim 6, wherein
the second attitude changing mechanism further includes:
a standby lifter configured to hold the processing substrate group in the vertical attitude; and
a second batch transport robot configured to transport the processing substrate group between the standby lifter and the reversing chuck, and
the controller
controls the first attitude changing mechanism to form the processing substrate group in which the plurality of substrates and the plurality of second substrates are alternately disposed and all device surfaces of the plurality of substrates and all device surfaces of the plurality of second substrates face each other, and to change the processing substrate group from the horizontal attitude to the vertical attitude, and
controls the second batch transport robot to transport the plurality of vertically-inverted substrates and the plurality of vertically-inverted second substrates to the standby lifter so as to make all the device surfaces of the plurality of substrates and all the device surfaces of the plurality of second substrates face each other.

8. The substrate processing system according to claim 1, wherein
the batch processing apparatus further includes a batch dryer configured to collectively dry the plurality of substrates,
the first batch transport robot is configured to transport the plurality of substrates among the first attitude changing mechanism, the lifter, the second attitude changing mechanism, and the batch dryer while holding the plurality of substrates in the vertical attitude, and
the controller
controls the first batch transport robot to transport the plurality of substrates subjected to the second batch processing to the batch dryer, and
controls the batch dryer to collectively dry the plurality of substrates subjected to the second batch processing.

9. A substrate processing method for a substrate processing system including a batch processing apparatus configured to collectively process a plurality of substrates, the batch processing apparatus including:
a carrier placement shelf on which a carrier accommodating the plurality of substrates in a horizontal attitude is placed;
a first attitude changing mechanism configured to change the plurality of substrates between the horizontal attitude and a vertical attitude;
a substrate handling mechanism configured to transport the plurality of substrates between the carrier placed on the carrier placement shelf and the first attitude changing mechanism;
a processing tank storing a chemical liquid;
a lifter configured to be able to immerse the plurality of substrates in the chemical liquid in the processing tank while holding the plurality of substrates in the vertical attitude; and
a first batch transport robot configured to transport the plurality of substrates while holding the plurality of substrates in the vertical attitude,
the substrate processing method comprising:
a first substrate transport step of causing the substrate handling mechanism to transport the plurality of substrates in the horizontal attitude received from the carrier placed on the carrier placement shelf, to the first attitude changing mechanism;
a vertical attitude changing step of causing the first attitude changing mechanism to change the plurality of substrates from the horizontal attitude to the vertical attitude;
a second substrate transport step of causing the first batch transport robot to transport the plurality of substrates changed to the vertical attitude to the lifter;
a first batch processing step of causing the lifter to perform first batch processing to immerse the plurality of substrates in the vertical attitude in the chemical liquid in the processing tank;
a third substrate transport step of causing the first batch transport robot to transport the plurality of substrates subjected to the first batch processing to a second attitude changing mechanism;
a vertical inversion step of causing the second attitude changing mechanism to rotate the plurality of substrates subjected to the first batch processing about a horizontal axis orthogonal to a central axis passing through a center of each substrate, to vertically invert the plurality of substrates in the vertical attitude;
a fourth substrate transport step of causing the first batch transport robot to transport the plurality of vertically-inverted substrates in the vertical attitude to the lifter; and
a second batch processing step of causing the lifter to perform second batch processing to immerse the plurality of vertically-inverted substrates in the vertical attitude in the chemical liquid in the processing tank.
